(19) Europäisches Patentamt
European Patent Office
Office européen des brevets

(11) **EP 3 497 411 B1**

(12) **EUROPÄISCHE PATENTSCHRIFT**

(45) Veröffentlichungstag und Bekanntmachung des Hinweises auf die Patenterteilung:
**15.04.2020 Patentblatt 2020/16**

(21) Anmeldenummer: **17742414.0**

(22) Anmeldetag: **14.07.2017**

(51) Int Cl.:
***G01F 1/84*** *(2006.01)*

(86) Internationale Anmeldenummer:
**PCT/EP2017/067826**

(87) Internationale Veröffentlichungsnummer:
**WO 2018/028932 (15.02.2018 Gazette 2018/07)**

(54) **TREIBERSCHALTUNG, DAMIT GEBILDETE UMFORMERELEKTRONIK UND DAMIT GEBILDETES MESSSYSTEM**

DRIVING CIRCUIT, CONVERTER ELECTRONICS MADE THEREWITH AND MEASUREMENT SYSTEM MADE THEREWITH

CIRCUIT DE COMMANDE, CONVERTISSEUR ÉLECTRONIQUE FABRIQUÉ AVEC CELUI-CI ET SYSTÈME DE MESURE FABRIQUÉ AVEC CELUI-CI

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.08.2016 DE 102016114860**

(43) Veröffentlichungstag der Anmeldung:
**19.06.2019 Patentblatt 2019/25**

(73) Patentinhaber: **Endress+Hauser Flowtec AG**
**4153 Reinach (CH)**

(72) Erfinder: **LALLA, Robert**
**79541 Lörrach (DE)**

(74) Vertreter: **Andres, Angelika Maria**
**Endress+Hauser (Deutschland) AG+Co. KG**
**PatServe**
**Colmarer Strasse 6**
**79576 Weil am Rhein (DE)**

(56) Entgegenhaltungen:
**WO-A1-93/22629 WO-A1-99/02945**
**WO-A2-2007/035376 US-A- 5 050 439**
**US-A1- 2003 056 574**

**Beschreibung**

Die Erfindung betrifft eine Treiberschaltung für eine, insb. induktive, Lastschaltung sowie eine damit gebildete, insb. eigensichere, Umformer-Elektronik bzw. ein, insb. als Zweileiter-Feldgerät ausgebildetes und/oder virbonisches, Meßsystem mit einer solchen Umformer-Elektronik.

In der industriellen Meß- und Automatisierungstechnik werden zur Erzeugung von Meßgrößen analog oder digital repräsentierenden Meßwertsignalen vor Ort oder prozeßnah installierte Meßsysteme - so genannte Feldgeräte - eingesetzt. Bei den jeweils zu erfassenden Meßgrößen kann es sich beispielsweise um einen Massendurchfluß bzw. eine Massendurchflußrate, eine Dichte, eine Viskosität, einen Füll- oder einen Grenzstand, einen Druck, eine Temperatur etc., eines strömungs- bzw. schüttfähigen, beispielsweise also flüssigen, pulver-, dampf- oder gasförmigen, Mediums handeln, das in einem entsprechenden Prozeßbehälter, wie z.B. einer Rohrleitung oder einem Tank, geführt bzw. vorgehalten wird. Weiterführende Beispiele für derartige, dem Fachmann an und für sich bekannte Feldgeräte sind u.a. in der DE-A 39 34 007, der EP-A 1 058 093, der EP-A 1 158 289, der EP-A 525 920, der EP-A 984 248, der US-A 37 64 880, der US-A 38 78 725, der US-A 43 08 754, der US-A 43 17 116, der US-A 44 68 971, der US-A 45 24 610, der US-A 45 74 328, der US-A 45 94 584, der US-A 46 17 607, der US-A 46 56 353, der US-A 47 68 384, der US-A 48 50 213, der US-A 49 26 340, der US-A 50 24 104, der US-A 50 52 230, der US-A 50 68 592, der US-A 51 31 279, der US-A 52 07 101, der US-A 52 31 884, der US-A 53 59 881, der US-A 53 63 341, der US-A 54 16 723, der US-A 54 69 748, der US-A 55 35 243, der US-A 56 04 685, der US-A 56 72 975, der US-A 56 87 100, der US-A 57 42 225, der US-A 57 42 225, der US-A 57 96 011, der US-A 59 59 372, der US-A 60 06 609, der US-A 60 14 100, der US-A 61 40 940, der US-B 62 36 322, der US-B 62 69 701, der US-B 62 85 094, der US-B 63 11 136, der US-B 63 97 683, der US-B 64 76 522, der US-B 64 80 131, der US-B 64 87 507, der US-B 65 12 358, der US-B 65 35 161, der US-B 65 74 515, der US-B 65 77 989, der US-B 66 62 120, der US-B 67 69 301, der US-B 67 76 053, der US-B 67 99 476, der US-B 72 00 503, der US-B 76 30 844, der US-A 2008/0015799, der US-A 2011/0271756, der US-A 2015/0177192, der WO-A 2014/163635, der WO-A 00/14485, der WO-A 00/26739, der WO-A 00/36379, der WO-A 00/48157, der WO-A 00/67087, der WO-A 01/02816, der WO-A 02/086426, der WO-A 02/103327, der WO-A 02/45045, der WO-A 2004/048905, der WO-A 2005/040735, der WO-A 2006/130087, WO-A 2010/014102, der WO-A 88/02476, der WO-A 88/02853 oder der WO-A 95/16897 ausführlich und detailliert beschrieben. Die darin gezeigten Meßsysteme weisen jeweils einen physikalisch-elektrischen Meßwandler zum Erfassen der jeweiligen Meßgröße(n) sowie eine damit elektrisch verbundene, zumeist von extern mit elektrischer Energie versorgte Umformer-Elektronik mit einer den Meßwandler steuernden - gelegentlich auch Betriebsschaltung bezeichneten - Schaltungsanordnung sowie einer damit verbundenen, beispielsweise mittels eines Mikrocontrollers und/oder mittels eines digitalen Signalprozessors gebildeten, Meß- und Steuerschaltung zum Erzeugen von die wenigstens eine Meßgröße repräsentierenden Meßwerten auf. Zur Aufnahme von nämliche Umformer-Elektronik bildenden Elektronikbaugruppen umfassen die Feldgeräte ferner ein Elektronik-Gehäuse, das, wie z.B. in der US-A 63 97 683 oder der WO-A 00/36379 vorgeschlagen, vom Meßwandler entfernt angeordnet und mit diesem nur über eine flexible Leitung verbunden sein kann oder das, wie z.B. auch in der EP-A 903 651 oder der EP-A 1 008 836 gezeigt, direkt am Meßwandler oder einem den Meßwandler separat einhausenden Meßwandler-Gehäuse angeordnet ist.

Der Meßwandler ist jeweils dafür vorgesehen, in eine Wandung des das Medium jeweils führenden Behälters oder der in den Verlauf einer das Medium jeweils führenden Leitung, beispielsweise eine Rohrleitung, eingesetzt zu werden, und dient dazu, wenigstens ein die wenigstens eine Meßgröße repräsentierendes elektrisches Meßsignal zu erzeugen. Dafür wird der jeweilige Meßwandler, nämlich ein darin vorgesehener Aktuator (Aktor) im Betrieb des Meßsystems von einem von der in der Umformer-Elektronik vorgesehenen Treiberschaltung generierten, beispielsweise bipolaren und/oder zumindest zeitweise periodischen, Treibersignal so angesteuert, daß er in einer für die Messung geeigneten Weise auf das Medium einwirkt, um dort mit der zu erfassenden Meßgröße korrespondierende, in das wenigstens eine Meßsignal entsprechend konvertierbare Reaktionen hervorzurufen. Das Treibersignal kann dabei beispielsweise ein hinsichtlich einer Stromstärke, einer Spannungshöhe und/oder einer Signalfrequenz entsprechend geregeltes Analog- oder auch ein geeignet getaktetes Binärsignal sein. Als Beispiele für solche aktiven, also ein elektrisches Treibersignal mittels eines, beispielsweise überwiegend induktiven, Aktuators bzw. Aktors in einen dem Erfassen der Meßgröße dienlichen Meßeffekt entsprechend umsetzende, Meßwandler sind im Besonderen nach dem Echoprinzip arbeitender HF-Sende-/Empfangswandler oder dem Messen von strömenden Medien dienende Durchfluß-Meßwandler mit wenigstens einer vom Treibersignal angesteuerten, Magnetfeld erzeugenden Spule, beispielsweise auch Meßwandler vom Vibrationstyp mit wenigstens einem vibrierenden Meßrohr und einem darauf einwirkenden elektro-mechanischen Schwingungserreger, oder wenigstens einem vom Treibersignal angesteuerten Ultraschallsender etc. zu nennen. Beispielsweise weist eine in der US-A 2011/0271756 gezeigte Treiberschaltung der in Rede stehenden Art u.a. einen Signalgenerator mit einem Frequenzsteuereingang, mit einem Amplitudensteuereingang und mit einem Signalausgang, sowie eine Endstufe mit einem Signaleingang und mit einem Lastausgang auf. Der Signalgenerator ist dafür eingerichtet, an dessen Signalausgang ein zumindest zeitweise periodisches, ggf. auch zumindest zeitweise harmonisches elektrisches Analogsignal mit einer durch einen am Frequenzsteuereingang anliegenden - beispielsweise nämlich von der Meß- und Steuerschaltung gelieferten - Frequenzsteuerwert vorgegebenen Signalfrequenz und einer durch einen am Amplitudensteuereingang anliegenden - beispielsweise nämlich ebenfalls von der Meß- und Steuerschaltung gelieferten - Amplitudensteuerwert vorgegebenen Spannungs- und/oder Stromamplitude auszugeben, während die Endstufe dafür eingerichtet ist, durch deren Lastausgang einen Laststrom mit einem von einer Signalspannung und/oder einem Signalstrom eines am Signaleingang anliegenden elektrischen Eingangssignals abhängigen Stromstärke zu treiben sowie eine Lastspannung mit einer von der Stromstärke des Laststroms abhängigen Spannungshöhe bereitzustellen. Bei der vorbezeichneten Treiberschaltung sind der Signalausgang des Signalgenerators mit dem Signaleingang der Endstufe und der Lastausgang der Endstufe mit einerhier als ein Bestandteil eines elektromechanischen oder elektro-magnetischen Aktors eines physikalisch-elektrischen Meßwandlers ausgebildete bzw. mittels wenigstens einer Spule gebildete - Lastschaltung elektrisch verbunden, derart, daß die Stromstärke des von der Endstufe ausgegebenen Laststroms von der Spannung und/oder dem Strom des vom Signalgenerator ausgegebenen elektrischen Analogsignals abhängig ist und daß die Lastspannung über der Lastschaltung abfällt. Zwecks des Erzeugens von die mittels des Meßsystems zu erfassende Meßgröße(n) repräsentierenden Meßwerten ist das wenigstens eine Meßsignal im weiteren Verlauf der vorbezeichneten in der Umformer-Elektronik vorgesehenen Meß- und Steuerschaltung zugeführt. Zudem ist die Meß- und Steuerschaltung dafür eingerichtet, entsprechende Steuerbefehle bzw. Einstellparameter für die Treiberschaltung zu berechnen, beispielsweise nämlich anhand eines Amplituden-Istwerts und eines Amplituden-Sollwerts einen aktuellen Amplitudensteuerwert und/oder anhand eines Frequenz-Istwerts und eines Frequenz-Sollwerts einen aktuellen Frequenzsteuerwert, und an nämliche Treiberschaltung zu übermitteln, beispielsweise in Form von Digitalwerten.

Meßsysteme der beschriebenen Art sind ferner üblicherweise über ein an die Umformer-Elektronik angeschlossenes Datenübertragungs-System miteinander und/oder mit einer entsprechenden, beispielsweise mittels Prozeß-Leitrechnern gebildeten, (zentralen) Auswerte-Einheit verbunden, wohin sie die Meßwertsignale z.B. via (4 mA bis 20 mA)-Stromschleife und/oder via digitalen DatenBus senden und/oder von denen sie Betriebsdaten und/oder Steuerbefehle in entsprechender Weise empfangen. Als Datenübertragungs-Systeme dienen hierbei, insb. serielle, Feldbus-Systeme, wie z.B. PROFIBUS-PA, FOUNDATION FIELDBUS sowie die entsprechenden Übertragungs-Protokolle. Mittels der Prozeß-Leitrechner können die übertragenen Meßwertsignale weiterverarbeitet und als entsprechende Meßergebnisse z.B. auf Monitoren visualisiert oder z.B. auch in der Prozeßführung dienliche Steuersignale für Stellgeräte, wie z.B. Magnet-Ventile, Elektro-Motoren etc., umgewandelt werden. Bei modernen Meßsystem der in Rede stehenden Art handelt es sich zudem oftmals um so genannte Zweileiter-Feldgeräte, also solche Feldgeräte, bei denen die Umformer-Elektronik mit der externen elektrischen Energieversorgung unter Bildung einer Stromschleife lediglich über ein einziges Paar elektrischer Leitungen elektrisch verbunden und von einem von der Energieversorgung gespeisten Versorgungsstrom durchflossen ist und bei denen die Umformer-Elektronik auch den momentanen Meßwert über dasselbe Paar elektrischer Leitungen an eine in der externen elektrischen Energieversorgung vorgesehene und/oder mit dieser elektrisch Feldgeräte ausgebildeten Meßsysteme können neben der vorbezeichneten US-A 2011/0271756 u.a. auch der WO 99/02945, der WO-A 05/040735, der WO-A 04/048905, WO-A 02/45045, der WO-A 02/103327, der WO-A 00/48157, WO-A 00/26739, der WO-A 94/20940, der US-B 67 99 476, der US-B 65 77 989, der US-B 66 62 120, der US-B 65 74 515, der US-B 65 35 161, der US-B 65 12 358, der US-B 64 80 131, der US-B 63 11 136, der US-B 62 85 094, der US-B 62 69 701, der US-A 61 40 940, der US-A 60 14 100, der US-A 59 59 372, der US-A 57 42 225, der US-A 56 72 975, der US-A 55 35 243, der US-A 54 16 723, der US-A 52 07 101, der US-A 50 68 592, der US-A 49 26 340, der US-A 46 56 353, der US-A 43 17 116, der US-A 37 64 880, der US-A 2008/0015799, US-B 72 00 503, US-B 76 30 844, der WO-A 00/67087, der WO-A 2010/014102, der EP-A 1 147 841, der EP-A 1 058 093, der EP-A 525 920 oder der DE-A 39 34 007 entnommen werden. Die vorbezeichneten Zweileiter-Feldgeräten können beispielsweise so ausgelegt sein, daß eine auf einen zwischen 4 mA und 20 mA (= Milliampere) liegenden Betrag eingestellte momentane Stromstärke des in dem als Teil einer Stromschleife dienenden einzigen Paar Leitung momentan fließenden Versorgungsstroms gleichzeitig auch den momentan vom Meßsystem erzeugten, analogen Meßwert repräsentiert. Infolgedessen besteht ein besonderes Problem von solchen Zweileiter-Feldgeräten auch darin, daß eine von der Umformer-Elektronik zumindest nominell umsetzbare bzw. umzusetzende, verfügbare elektrisch Leistung während des Betriebes in praktisch unvorhersehbarer Weise über einen weiten Bereich schwanken kann.

Meßsysteme der in Rede stehenden Art sind zudem oftmals auch so ausgebildet, daß sie den Forderungen nach intrinsischer Explosionssicherheit genügen. Demnach wird ein derartiges Feldgerät lediglich mit einer solch niedrigen elektrischen Leistung betrieben, daß mangels des Erreichens der Zündbedingungen Funken oder Lichtbogen elektrisch nicht ausgelöst bzw. daß innerhalb des Feldgeräts auch punktuell keine Zündtemperaturen erreicht werden können. Eigensicherere Explosionsschutz ist beispielsweise nach den Europäischen Normen EN 50 014 und EN 50 020 gegeben bzw. der der darin definierten Zündschutzart "Eigensicherheit (Ex-i)" ist dann entsprochen, wenn elektronische Vorrichtungen, mithin Feldgeräte, so ausgebildet sind, daß darin maximal auftretende elektrische Ströme, Spannungen und Leistungen vorgegebene Strom-, Spannungs- und Leistungsgrenzwerte keinesfalls überschreiten. Nämlich Grenzwerte sind jeweils so gewählt, daß im Fehlerfall, etwa einem einen Kurzschluß, die maximal freigesetzte Energie nicht dazu ausreicht, einen zündfähigen Funken zu erzeugen, bzw. die maximal umgesetzte elektrische Leistung 1 W (= Watt) nicht übersteigt. Die Spannung kann z.B. passiv durch Z-Dioden, der Strom, beispielsweise nämlich auch der vorbezeichnete Laststrom, passiv durch entsprechende Begrenzungswiderstände und die (maximal verfügbare) Leistung durch entsprechende Kombination von aktiven und/oder passiven spannungs- und strombegrenzenden Komponenten unter den vorgegebenen Grenzwerten gehalten werden.

Bei Meßsystemen der in Rede stehenden Art kann es daher gelegentlich vorkommen, daß die für einen optimalen Betrieb der den Meßwandler involvierenden Lastschaltung eigentlich benötigte Stromstärke des Laststroms mittels der Endstufe der Treiberschaltung mitunter nicht mehr eingestellt, mithin das den Meßwandler speisende Treibersignal gelegentlich nicht mit der erforderlichen Signalqualität geliefert werden kann, beispielsweise nämlich für den gelegentlich auftretenden Fall, daß die momentan verfügbare elektrische Leistung im Verhältnis zu der in der Treiberschaltung für einen optimalen Betrieb momentan eigentlich benötigten Leistung aufgrund von Meßsystem bedingten Limitierungen zu gering ist, bzw. für den Fall, daß aufgrund eines zu niedrigen Signalpegels des Meßsignals von der Meß- und Steuerschaltung Steuerbefehle bzw. Einstellparameter an die Treiberschaltung gesendet werden, die zu einem Übersteuern von deren Endstufe einhergehend mit einer Verzerrung des Laststroms bzw. der Lastspannung (Clipping) führen können. Solche Überlastungssituationen der Treiberschaltung können im Falle eines als Zweileiter-Feldgeräts ausgebildeten Meßsystems u.a infolge eines minimalen Betrags der zu erfassenden Meßgröße und/oder im Falle eines mittels eines Meßwandler vom Vibrationstyp gebildeten, ggf. auch eigensicher ausgelegten, vibronischen Meßsystems infolge einer sehr hohen und/oder rasch zunehmenden mechanischen Dämpfung der angeregten mechanischen Schwingungen des wenigstens einen Meßrohrs auftreten, wie sie. u.a. beim Messen einer hochviskosen Flüssigkeit und/oder einer Dispersion, wie z.B. einer Gaseinschlüsse aufweisenden Flüssigkeit, oder bei zu hoher Gegeninduktion in der (induktiven) Lastschaltung bzw. während des eines Aufstartens des Meßsystems beobachtet werden. Wie u.a. in der eingangs erwähnten US-A 2011/0271756 oder US-A 2015/0177192 erörtert, kann es beispielsweise bei einem vibronischen Meßsystem der vorbezeichneten Art zwecks Sicherstellung der angestrebten hohen Meßgenauigkeit umgekehrt jedoch erforderlich sein, daß der in dem jeweiligen Aktuator bzw. der damit gebildeten Lastschaltung fließende Laststrom, zumindest aber eine mit dem zu nutzenden Meßeffekt korrespondierende spektralen Komponente davon, hinsichtlich Amplitude, Phasenlage und zeitlichem Verlauf, beispielsweise etwa einer möglichst idealen Sinusform, während der Messung zuvor spezifizierten Vorgaben möglichst genau entspricht; dies beispielsweise deshalb, um sicherzustellen, daß Schwingungen des wenigstens einen Meßrohrs lediglich in einem bestimmten Schwingungsmode und/oder mit einer bestimmten Frequenz angeregt werden bzw. daß ein Anregen von unerwünschten Schwingungen bzw. Frequenzen vermieden wird, bzw. um sicherzustellen, daß das Meßsystem stabil in einem spezifizierten Arbeitsbereich operiert. Zudem kann es auch erforderlich sein, während des Betriebs des Meßsystems den Laststrom gelegentlich gezielt abzusenken, etwa um Diagnosefunktionen im Meßsystem ausführen zu können.

Bei einer US-A 2015/0177192 gezeigten Umformer-Elektronik werden zwecks einer Vermeidung bzw. frühzeitigen Detektion von Überlastungen der Treiberschaltung mittels der Meß- und Steuerschaltung fortwährend sowohl die ausgangs der Endstufe, mithin über der Lastschaltung abfallende Lastspannung als auch der von der Endstufe getriebene bzw. durch die Lastschaltung fließende Laststrom gemessen und ausgewertet. Sobald dadurch erkannt wird, daß eine solche Überlastsituation gegeben ist oder sich anbahnt, daß nämlich beispielsweise der Laststrom einen dafür vorgegebenen, einen maximal zulässigen Laststrom repräsentierenden Schwellenwert überschreitet oder die Lastspannung einen dafür vorgegebenen, eine maximal zulässige Lastspannung repräsentierenden Schwellenwert überschreitet oder aber eine in der Lastschaltung momentan umgesetzte elektrische Leistung einen dafür vorgegebenen, eine maximal zulässige Leistung repräsentierenden Schwellenwert überschreitet, wird ein entsprechend reduzierter Amplituden-Sollwert für die jeweils einzustellende Schwingungsamplitude des wenigstens einen Meßrohrs vorgegeben bzw. von der Meß- und Steuerschaltung an die Treiberschaltung übermittelt.

Ein Nachteil eines solchen Verfahrens bzw. einer solchen Schaltungsanordnung besteht allerdings darin, daß dafür zusätzliche elektronische Komponenten und Baugruppen, wie z.B. einen vom Laststrom durchflossenen, mithin auf die Treiberschaltung rückwirkenden Sensewiderstand für eine Laststrom proportionale Meßspannung sowie wenigstens zwei zusätzliche A/D-Wandler für die Digitalisierung von Laststrom bzw. -spannung, die wiederum den Leistungsbedarf der Treiberschaltung noch mehr erhöhen.

Ausgehend davon besteht eine Aufgabe der Erfindung darin, eine für Meßsysteme mit aktivem Meßwandler, mithin auch für Zweileiter-Feldgeräte und/oder für vibronische Meßsysteme, geeignete Treiberschaltung anzugeben, bei der auch ohne direktes Messen des Laststroms vorbezeichnete Überlastsituationen vermieden oder zumindest frühzeitig detektiert und somit rasch wieder abgestellt werden können; dies im besonderen auch in der Weise, daß ein fortwährendes Übersteuern der jeweiligen Endstufe bzw. ein unerkanntes bzw. fortwährendes Betreiben der Endstufe in einem nicht mehr linearen Sättigungsbereich vermieden werden kann.

Zur Lösung der Aufgabe besteht die Erfindung in einer Treiberschaltung, umfassend: einen Signalgenerator mit einem Frequenzsteuereingang, mit einem Amplitudensteuereingang und mit einem Signalausgang, eine - beispielsweise mittels einer (bipolaren) Gleichspannung betriebene - Endstufe mit einem Signaleingang und mit einem Lastausgang, sowie eine - beispielsweise mittels eines Mikroprozessors gebildete - Amplitudensteuerung mit einem - digitalen oder analogen - Amplitudeneingang, mit einem - digitalen oder analogen - Amplitudenausgang und mit einem Spannungsmeßeingang. Der Signalgenerator ist im besonderen dafür eingerichtet, an dessen Signalausgang ein zumindest zeitweise periodisches - beispielsweise auch zumindest zeitweise harmonisches - elektrisches Analogsignal mit einer durch einen am Frequenzsteuereingang anliegenden - digitalen oder analogen - Frequenzsteuerwert vorgegebenen Signalfrequenz und einer durch einen am Amplitudensteuereingang anliegenden - digitalen oder analogen - Amplitudensteuerwert vorgegebenen Spannungs- und/oder Stromamplitude auszugeben. Die Endstufe der erfindungsgemäßen Treiberschaltung ist dafür eingerichtet, durch einen nämlichen Lastausgang involvierenden Stromkreis einen Laststrom mit einem von einer Signalspannung und/oder einem Signalstrom eines am Signaleingang anliegenden elektrischen Eingangssignals abhängigen Stromstärke zu treiben sowie an nämlichem Lastausgang eine Lastspannung mit einer von der Stromstärke des Laststroms abhängigen Spannungshöhe bereitzustellen. Darüberhinaus ist die Amplitudensteuerung der erfindungsgemäßen Treiberschaltung dafür eingerichtet, wiederkehrend eine Amplituden-Abweichung, nämlich eine - relative oder absolute - Abweichung zwischen einem am Amplitudeneingang anstehenden Amplituden-Istwert und einem, beispielsweise nämlich in der Amplitudensteuerung vorgehaltenen und/oder an diese übermittelten, Amplituden-Sollwert zu ermitteln. Zudem ist die Amplitudensteuerung dafür eingerichtet, wiederkehrend einen Indikatorwert zu ermitteln, der signalisiert, ob ein Betrag einer am Spannungsmeßeingang anliegenden Meßspannung zu hoch ist, nämlich ob der Betrag einen, beispielsweise nämlich in der Amplitudensteuerung vorgehaltenen und/oder an diese übermittelten, Schwellenwert überschritten hat, und unter Verwendung nämlichen Indikatorwerts einen, insb. dem Verringern bzw. Minimieren der Amplituden-Abweichung dienlichen und/oder digitalen, Amplitudensteuerwert zu ermitteln, derart, daß bei einem zu hohen Betrag der Meßspannung aufeinanderfolgende Amplitudensteuerwerte der Amplitudensteuerfolge, insb. auch bei einer zunehmenden Amplituden-Abweichung und/oder sukzessive, verringert werden, sowie am Amplitudenausgang eine Amplitudensteuerfolge, nämlich eine Folge von zeitlich nacheinander berechnete Amplitudensteuerwerten auszugeben. Bei der erfindungsgemäßen Treiberschaltung sind zudem der Signalausgang des Signalgenerators mit dem Signaleingang der Endstufe und der Lastausgang der Endstufe mit dem Spannungsmeßeingang der Amplitudensteuerung elektrisch verbunden, derart, daß die Stromstärke des von der Endstufe ausgegebenen Laststroms von der Spannung und/oder dem Strom des vom Signalgenerator ausgegebenen elektrischen Analogsignals abhängig ist und daß die Lastspannung am Spannungsmeßeingang der Amplitudensteuerung anliegt, und ist zudem der Amplitudenausgang der Amplitudensteuerung mit dem Amplitudensteuereingang des Signalgenerators elektrisch verbunden, derart, daß die Spannungs- und/oder Stromamplitude des Analogsignals durch am Amplitudensteuereingang anliegende Amplitudensteuerwerte der Amplitudensteuerfolge vorgegeben sind.

Ferner besteht die Erfindung in einer Umformer-Elektronik mit einer solchen Treiberschaltung und mit einer, beispielsweise als ein Bestandteil eines elektro-mechanischen oder elektro-magnetischen Aktors eines physikalisch-elektrischen Meßwandlers ausgebildete und/oder mittels wenigstens einer Spule gebildete, Lastschaltung. Bei der erfindungsgemäßen Umformer-Elektronik ist zudem der Lastausgang der Endstufe sowohl mit dem Spannungsmeßeingang der Amplitudensteuerung als auch mit der Lastschaltung elektrisch verbunden, derart, daß die Lastspannung sowohl am Spannungsmeßeingang der Amplitudensteuerung anliegt als auch über der Lastschaltung abfällt.

Darüberhinaus besteht die Erfindung in einem Meßsystem mit einer solchen, beispielsweise auch eigensicheren, Umformer-Elektronik sowie mit einem an nämliche Umformer-Elektronik elektrisch angeschlossenen Meßwandler, der dafür eingerichtet ist, wenigstens eine physikalische Meßgröße, beispielsweise nämlich einer Massendurchflußrate und/oder einer Dichte und/oder einer Viskosität eines in einer Rohrleitung geführten Fluids oder eines Füllstands eines in einem Behälter vorgehaltenen schüttfähigen Mediums, zu erfassen und in ein korrespondierendes Meßsignal zu wandeln, derart, daß das Meßsignal einer Änderung nämlicher physikalischen Meßgröße mit einer Änderung einer wenigstens eines Signalparameters, beispielsweise einer Signalamplitude, einer Signalfrequenz und/oder eines Phasenwinkels, folgt.

Nach einer ersten Ausgestaltung der Treiberschaltung der Erfindung ist vorgesehen, daß die Amplitudensteuerung dafür eingerichtet ist, einen zeitlichen Anteil, mit dem die Meßspannung für ein vorgegebenes Meßintervall insgesamt zu hoch ist, zu ermitteln und daß die Amplitudensteuerung dafür eingerichtet ist, den Indikatorwert so zu ermitteln, daß dieser nämlichen zeitlichen Anteil, beispielsweise relativ bzw. bezogen auf nämliches Meßintervall, quantifiziert.

Nach einer zweiten Ausgestaltung der Treiberschaltung der Erfindung ist vorgesehen, daß die Lastspannung, mithin die am Spannungsmeßeingang der Amplitudensteuerung anliegende Meßspannung zumindest zeitweise einen periodischen Verlauf aufweisen, beispielsweise derart, daß die Lastspannung bzw. die Meßspannung über einen Zeitraum von wenigstens zwei Perioden mit einer vorgegebenen, nämlich dem Frequenzsteuerwert entsprechenden Frequenz ändert.

Nach einer dritten Ausgestaltung der Treiberschaltung der Erfindung ist vorgesehen, daß die Amplitudensteuerung eingerichtet ist, bei einem zu hohen Betrag der Meßspannung einen jeweiligen nächsten Amplitudensteuerwert jeweils so zu berechnen, daß nämlicher Amplitudensteuerwert kleiner ist als ein jeweils vorheriger Amplitudensteuerwert.

Nach einer vierten Ausgestaltung der Treiberschaltung der Erfindung ist vorgesehen, daß die Amplitudensteuerung eingerichtet ist, den Indikatorwert so zu ermitteln, daß dieser signalisiert, ob der Betrag der am Spannungsmeßeingang anliegenden Meßspannung zu niedrig ist, nämlich ob der Betrag zumindest den Schwellenwert unterschritten hat.

Nach einer fünften Ausgestaltung der Treiberschaltung der Erfindung ist vorgesehen, daß die Amplitudensteuerung eingerichtet ist, Amplitudensteuerwerte so zu berechnen, daß bei einem zu niedrigen Betrag der Meßspannung aufeinanderfolgende Amplitudensteuerwerte der Amplitudensteuerfolge, beispielsweise sukzessive, erhöht werden.

Nach einer sechsten Ausgestaltung der Treiberschaltung der Erfindung ist vorgesehen, daß die Amplitudensteuerung eingerichtet ist, eine mit dem Indikatorwert gewichtete Amplituden-Abweichung zu berechnen, derart, daß nämliche gewichtete Amplituden-Abweichung bei zu hoher Meßspannung kleiner ist als die Amplituden-Abweichung.

Nach einer siebenten Ausgestaltung der Treiberschaltung der Erfindung ist vorgesehen, daß die Amplitudensteuerung eingerichtet ist, einen mit dem Indikatorwert gewichteten Amplituden-Sollwert zu berechnen, derart, daß nämlicher gewichteter Amplituden-Sollwert bei zu hoher Meßspannung kleiner ist als der Amplituden-Sollwert.

Nach einer achten Ausgestaltung der Treiberschaltung der Erfindung ist vorgesehen, daß die Amplitudensteuerung dafür eingerichtet ist, zu ermitteln, in welchem Maße die Meßspannung zu hoch ist bzw. ein Ausmaß, um das die Meßspannung zu hoch ist, zu quantifizieren.

Nach einer neunten Ausgestaltung der Treiberschaltung der Erfindung ist vorgesehen, daß die Amplitudensteuerung dafür eingerichtet ist, den Indikatorwert so zu ermitteln, daß nämlicher Indikatorwert ein Ausmaß, um das die Meßspannung zu hoch ist, quantifiziert.

Nach einer zehnten Ausgestaltung der Treiberschaltung der Erfindung ist vorgesehen, daß die Amplitudensteuerung einen ersten Komparator mit einem nicht-invertierenden Spannungseingang und mit einem invertierenden Spannungseingang aufweist, wobei der Spannungsmeßeingang der Amplitudensteuerung mittels nämlichen nicht-invertierenden Spannungseingangs gebildet ist, und wobei nämlichem invertierenden Spannungseingang eine erste Referenzspannung angelegt ist. Diese Ausgestaltung der Erfindung weiterbildend ist ferner vorgesehen, daß die Amplitudensteuerung einen zweiten Komparator mit einem nicht-invertierenden Spannungseingang und mit einem invertierenden Spannungseingang aufweist, wobei der Spannungsmeßeingang der Amplitudensteuerung mittels nämlichen invertierenden Spannungseingangs gebildet ist und wobei nämlichem nicht-invertierenden Spannungseingang eine von der ersten Referenzspannung abweichende zweite Referenzspannung angelegt ist.

Nach einer ersten Ausgestaltung der Umformer-Elektronik der Erfindung ist vorgesehen, daß die Lastschaltung eine Spule aufweist

Nach einer zweiten Ausgestaltung der Umformer-Elektronik der Erfindung ist vorgesehen, daß die Lastschaltung ein, insb. dem Begrenzen des Laststroms auf eine Eigensicherheit der Lastschaltung bzw. der Umformer-Elektronik gewährleistende Stromstärke dienliches, Widerstandselement aufweist.

Nach einer ersten Weiterbildung der Umformer-Elektronik der Erfindung umfaßt diese weiters eine Zweileiter-Anschlußschaltung zum Anschließen der Umformer-Elektronik an eine davon entfernte Auswerte- und Versorgungseinheit.

Nach einer ersten Ausgestaltung der ersten Weiterbildung der Umformer-Elektronik ist die Zweileiter-Anschlußschaltung dafür eingerichtet, für den Betrieb der Treiberschaltung erforderliche elektrische Leistung von der Auswerte- und Versorgungseinheit, beispielsweise via (4 mA bis 20 mA-) Stromschleife, zu beziehen.

Nach einer ersten Ausgestaltung der zweiten Weiterbildung der Umformer-Elektronik ist die Zweileiter-Anschlußschaltung dafür eingerichtet, mittels der Meß- und Steuerschaltung generierte Meßdaten an die Auswerte- und Versorgungseinheit, insb. durch Modulation eines in der Zweileiter-Anschlußschaltung fließenden und/oder der Bereitstellung von elektrischer Leistung für die Treiberschaltung und/oder die Meß- und Steuerschaltung dienenden Stromes, zu übermitteln.

Nach einer zweiten Weiterbildung der Umformer-Elektronik der Erfindung umfaßt diese weiters eine Meß- und Steuerschaltung mit einem Meßsignaleingang, mit einem, beispielsweise digitalen, Frequenzausgang und mit einem, beispielsweise digitalen, Amplitudenausgang,

Nach einer ersten Ausgestaltung der zweiten Weiterbildung der Umformer-Elektronik ist die Meßschaltung dafür eingerichtet, von einem am Meßsignaleingang anliegenden Eingangssignal sowohl eine Signalfrequenz als auch eine Signalamplitude zu ermitteln,

Nach einer zweiten Ausgestaltung der zweiten Weiterbildung der Umformer-Elektronik ist die Meß- und Steuerschaltung ferner dafür eingerichtet, am Amplitudenausgang eine Amplitudenfolge, nämlich eine Folge von anhand des Eingangssignals ermittelten, beispielswiese nämlich die Signalamplitude des Eingangssignals quantifizierenden und/oder digitalen, Amplitudenwerten und am Frequenzausgang eine Frequenzfolge, nämlich eine Folge von anhand des Eingangssignals ermittelten, beispielsweise nämlich eine für das Eingangssignal einzustellende Signalfrequenz quantifizierende und/oder digitalen, Frequenzwerten auszugeben.

Nach einer Ausgestaltung des Meßsystems der Erfindung ist vorgesehen, daß der Frequenzausgang der Meß- und Steuerschaltung mit dem Frequenzsteuereingang des Signalgenerators der Treiberschaltung elektrisch verbunden ist, derart, daß der an dessen Frequenzsteuereingang anliegende Frequenzsteuerwert einem Frequenzwert der Frequenzfolge entspricht, daß der Amplitudenausgang der Meß- und Steuerschaltung mit dem Amplitudeneingang der Amplitudensteuerung der Treiberschaltung elektrisch verbunden ist, derart, daß der an deren Amplitudeneingang anstehende Amplituden-Istwert einem Amplitudenwert der Amplitudenfolge entspricht und daß der Meßwandler mit dem Meßsignaleingang der Meß- und Steuerschaltung elektrisch gekoppelt ist, derart, daß die Meß- und Steuerschaltung das wenigstens eine Meßsignal empfängt und daß sowohl die Frequenz- als auch die Amplitudenfolge vom Meßsignal abhängig ist. Diese Ausgestaltung der Erfindung weiterbildend ist ferner vorgesehen, daß der Meßwandler mit der Lastschaltung elektrisch und/oder elektro-magnetisch gekoppelt ist, derart, daß ein zeitlicher Verlauf des Meßsignals von einem zeitlichen Verlauf des Laststroms und/oder der Lastspannung abhängig ist, beispielsweise derart, daß eine Signalfrequenz des Meßsignals von einer Frequenz des Laststroms bzw. der Lastspannung abhängig ist und/oder derart, daß eine Signalamplitude des Meßsignals von der Stromstärke des Laststroms und/oder der Spannungshöhe der Lastspannung abhängig ist und/oder daß der Meßwandler ein, beispielsweise mit einem mit einer Spule der Lastschaltung wechselwirkenden Magneten mechanisch verbundenes, Meßrohr aufweist, das dafür eingerichtet ist, einen fluiden Meßstoff zu führen, beispielsweise nämlich von einem fluiden Meßstoff durchströmt und währenddessen vibrieren gelassen zu werden bzw. daß der Meßwandler einen Permanentmagneten aufweist, der mit einer in die Lastschaltung eingegliederten Spule wechselwirkt. Alternativ oder in Ergänzung kann die Meß- und Steuerschaltung ferner dafür eingerichtet sein, basierend auf dem Meßsignal die wenigstens eine physikalische Meßgröße repräsentierende - digitale und/oder analoge - Meßwerte zu ermitteln.

Nach einer Weiterbildung des Meßsystems der Erfindung umfaßt dieses weiters eine, insb. von der Umformer-Elektronik entfernte, Auswerte- und Versorgungseinheit, wobei die Umformer-Elektronik an nämliche Auswerte- und Versorgungseinheit angeschlossen ist.

Nach einer ersten Ausgestaltung Weiterbildung des Meßsystems ist vorgesehen, daß die Umformer-Elektronik für den Betrieb der Treiberschaltung erforderliche elektrische Leistung von der Auswerte- und Versorgungseinheit bezieht.

Nach einer zweiten Ausgestaltung Weiterbildung des Meßsystems ist vorgesehen, daß die Umformer-Elektronik mittels der Meß- und Steuerschaltung generierte Meßdaten, beispielsweise jeweils eine Massendurchflußrate eines in einer Rohrleitung strömenden Mediums repräsentierende Massendurchfluß-Meßwerte, jeweils eine Dichte eines Mediums repräsentierende Dichte-Meßwerte, oder jeweils eine Viskosität eines Mediums repräsentierende Viskositäts-Meßwerte, an die Auswerte- und Versorgungseinheit, beispielsweise nämlich durch Modulation eines in einer in der Umformer-Elektronik vorgesehene Zweileiter-Anschlußschaltung fließenden Stromes, übermittelt.

Ein Grundgedanke der Erfindung besteht darin, eine sich anbahnende bzw. tatsächlich auftretende Überlastsituation für die Treiberschaltung einhergehend mit einer Verzerrung des Laststroms indirekt, nämlich anhand eines Überschreitens von entsprechend vorgegebenen Schwellenwerten durch die sich währenddessen einstellenden, ggf. nach wie vor nicht verzerrte Lastspannung sehr rasch zu detektieren. Sobald der Betrag der Lastspannung als zu hoch detektiert ist kann durch Herabsenken des Amplitudensteuerwerts für den Signalgenerator die Treiberschaltung auf sehr einfache gleichwohl effektive Weise wieder in einen linearen Arbeitsbereich zurückgeführt werden. Ein Vorteil der Erfindung besteht u.a. darin, daß die Detektion der Überlastsituation zum einen sehr kostengünstig und zum anderen mit einem sehr geringen Bedarf an zusätzlicher elektrischer Leistung realisiert werden kann. Ein weiterer Vorteil der Erfindung ist aber auch darin zu sehen, daß die erfindungsgemäße Detektion von Überlastsituationen in Treiberschaltungen auch in bereits etablierte Schaltungskonzepte integriert werden kann. Bei vibronischen Meßsystemen beispielsweise kann dies auch unter weitgehender Beibehaltung der der jeweiligen Treiberschaltung vorgelagerten Amplitudenreglung für die mechanischen Schwingungen erfolgen.

Die Erfindung sowie weitere vorteilhafte Ausgestaltungen davon werden nachfolgend anhand von Ausführungsbeispielen näher erläutert, die in den Figuren der Zeichnung dargestellt sind. Gleiche Teile sind in allen Figuren mit denselben Bezugszeichen versehen; wenn es die Übersichtlichkeit erfordert oder es anderweitig sinnvoll erscheint, wird auf bereits erwähnte Bezugszeichen in nachfolgenden Figuren verzichtet. Weitere vorteilhafte Ausgestaltungen oder Weiterbildungen, insb. auch Kombinationen zunächst nur einzeln erläuterter Teilaspekte der Erfindung, ergeben sich ferner aus den Figuren der Zeichnung wie auch den Unteransprüchen an sich.

Im einzelnen zeigen:

Fig. 1   ein - hier als Kompakt-Meßgerät ausgebildetes - Meßsystem für in Rohrleitungen strömende Medien;

Fig. 2   schematisch nach Art eines Blockschaltbildes eine Ausgestaltungsvariante eines Meßsystem gemäß den Fig. 1 mit einer Umformer-Elektronik und einem daran angeschlossenen aktiven Meßwandler;

Fig. 3   schematisch nach Art eines Blockschaltbildes eine für eine Umformer-Elektronik gemäß Fig. 2, mithin ein Meßsystem gemäß den Fig. 1 geeignete Treiberschaltung für einen - hier als ein Meßwandler vom Vibrationstyp mit wenigstens einem schwingenden Meßrohr ausgebildeten - aktiven Meßwandler;

Fig. 4   schematisch nach Art eines Blockschaltbildes eine Ausgestaltungsvariante für eine Treiberschaltung gemäß Fig. 3; und

Fig. 5   eine zeitlichen Verlauf einer in einer Treiberschaltung gemäß Fig. 3 bzw. 4 detektierbaren (Meß-)Spannung.

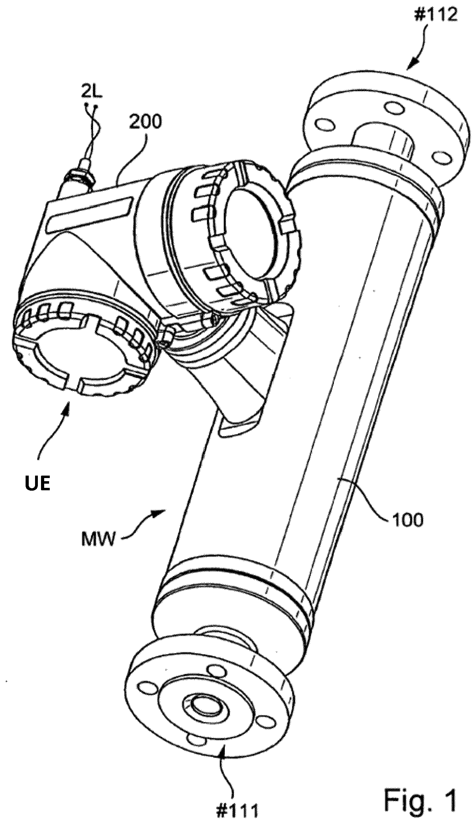

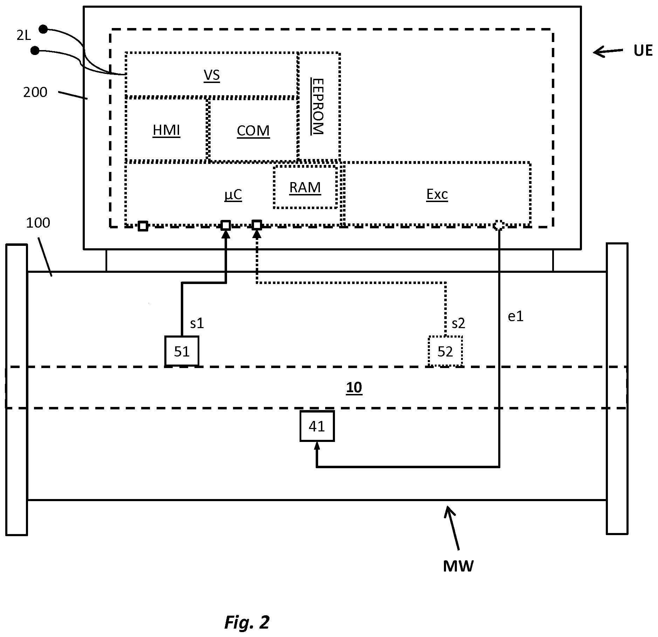

In der Fig. 1 bzw. 2 ist ein in eine (nicht dargestellte) Prozeßleitung, etwa eine Rohrleitung einer industriellen Anlage, einfügbares, beispielsweise mittels eines Coriolis-Massendurchflußmeßgerät, Dichtemeßgerät, Viskositätsmeßgerät oder dergleichen gebildetes, Meßsystem für fließfähige, insb. fluide bzw. schüttfähigen, Medien, dargestellt, das im hier gezeigten Ausführungsbeispiel dem Messen und/oder Überwachen wenigstens einer weiteren physikalischen Meßgröße eines in der Rohrleitung geführten bzw. darin strömen gelassenen Mediums dient, wie etwa einer Massendurchflußrate, einer Dichte, einer Viskosität oder dergleichen. Das - hier mittels eines In-Line-Meßgeräts in Kompaktbauweise realisierte - Meßsystem umfaßt dafür einen über ein Einlaßende #111 sowie ein Auslaßende #112 an die Prozeßleitung angeschlossenen physikalisch-elektrischen Meßwandler MW, der an eine, insb. im Betrieb von extern via Anschlußkabel und/oder mittels interner Energiespeicher mit elektrischer Energie versorgte, Umformer-Elektronik UE des Meßsystems angeschlossen ist. Nach einer Ausgestaltung der Erfindung ist der Meßwandler im besonderen dafür eingerichtet, die wenigstens eine physikalische Meßgröße so zu erfassen und in das korrespondierende, beispielsweise nämlich elektrisches, Meßsignal zu wandeln, derart, daß nämliches Meßsignal einer Änderung nämlicher physikalischen Meßgröße mit einer Änderung einer wenigstens eines Signalparameters, beispielsweise einer Signalamplitude, einer Signalfrequenz und/oder einem Phasenwinkel, folgt. Dafür ist nach einer weiteren Ausgestaltung der Erfindung im Meßwandler eine, beispielsweise mittels wenigstens eines Sensors 51 oder, wie auch in Fig. 2 angedeutet mittels eines weiteren (zweiten), beispielsweise zum Sensor 51 baugleichen, Sensors 52 gebildete Sensoranordnung vorgesehen. Bei dem wenigstens Sensor 51 kann es sich beispielsweise um einen elektrodynamischen, beispielsweise nämlich wenigstens eine Spule $L_{sens}$ aufweisenden, Schwingungssensor zum Erfassen von mechanischen Schwingungen des Meßwandlers handeln, mithin können die von der Sensoranordnung gelieferten Meßsignale s1, s2 dementsprechend Schwingungsmeßsignale sein.

Bei dem Meßwandler MW handelt es sich zudem um einen ein - hier von der Umformer-Elektronik UE geliefertes - elektrisches, beispielsweise bipolares und/oder zumindest zeitweise periodisches, Treibersignal e1 bzw. dessen elektrische Signalleistung mittels eines Aktors 41, beispielsweise nämlich einem elektro-mechanischen, elektro-akustischen oder elektro-magnetischen Erreger, in einen dem Erfassen der Meßgröße dienlichen Meßeffekt - wie etwa Corioliskräfte oder induzierte elektrische Spannungen im Medium - entsprechend umsetzenden aktiven Meßwandler. Der Meßwandler MW kann demnach beispielsweise ein im Betrieb entsprechend vom zu messenden Medium, wie etwa einer Flüssigkeit und/oder einem Gas, durchströmter Durchfluß-Meßwandler, wie etwa ein Meßwandler vom Vibrationstyp mit einem Meßrohr, das dafür eingerichtet ist, einen fluiden Meßstoff zu führen, insb. nämlich von einem fluiden Meßstoff durchströmt und währenddessen vibrieren gelassen zu werden, und mit einem darauf einwirkenden elektro-mechanischen Schwingungserreger, ein magnetisch-induktiver Meßwandler für leitfähige Flüssigkeiten oder ein wenigstens einen akustischen Sender aufweisenden Ultraschall-Meßwandler für Fluide, sein oder aber beispielsweise auch ein nach dem Echoprinzip arbeitender HF-Sende-/Empfangswandler für elektromagnetische Mikrowellen. Für den erwähnten Fall, daß es sich bei dem Meßwandler MW um einen solchen vom Vibrationstyp für strömende Medien handelt ist nach einer Ausgestaltung der Erfindung ferner vorgesehen, daß der Meßwandler wenigstens ein mittels des, beispielsweise als elektrodynamischer Schwingungserreger ausgebildeten und/oder mittels einer Tauchanker-Spulen-Anordnung ($L_{exc}$) gebildeten, mithin also induktiven, Aktors 41 zu mechanischen Schwingungen angeregtes Meßrohr 10 aufweist. Als Schwingungen können beispielsweise solche dienen, die infolge von Corioliskräften im durch den Meßwandler strömenden Medium eine von einer momentanen Massendurchflußrate abhängige Schwingungsform und/oder eine von einer momentanen Dichte des im Meßwandler geführten Mediums abhängige Nutzfrequenz und/oder eine von einer momentanen Viskosität des im Meßwandler geführten Mediums abhängige Dämpfung aufweisen. Nämliches Meßrohr 10 kann - wie auch in Fig. 2 angedeutet bzw. aus einer Zusammenschau der Fig. 1 und 2 ohne weiteres ersichtlich - zusammen mit dem Aktor 41 und ggf. weiteren Komponenten des Meßwandlers innerhalb eines Meßwandler-Gehäuses 100 untergebracht sein.

In vorteilhafter Weise kann die, insb. programmierbare und/oder fernparametrierbare, Umformer-Elektronik ME ferner so ausgelegt sein, daß sie im Betrieb des Meßsystems mit einem diesem übergeordneten (hier nicht dargestellten) elektronischen Datenverarbeitungssystem, beispielsweise einer speicherprogrammierbaren Steuerung (SPS), einem Personalcomputer und/oder einer Workstation, via Datenübertragungssystem, beispielsweise einem Feldbussystem und/oder drahtlos per Funk, Meß- und/oder andere Betriebsdaten austauschen kann, wie etwa aktuelle Meßwerte oder der Steuerung des Meßsystems dienende Einstell- und/oder Diagnosewerte. Dabei kann die Umformer-Elektronik UE beispielsweise eine solche Anschlußschaltung aufweisen, die im Betrieb von einer im vorbezeichneten Datenverarbeitungssystem vorgesehen, vom Meßsystem entfernten (zentrale) Auswerte- und Versorgungseinheit gespeist wird. Beispielsweise kann die Umformer-Elektronik UE hierbei ferner so ausgebildet sein, daß sie über eine, beispielsweise als 4-20 mA-Stromschleife konfigurierten, Zweileiter-Verbindung 2L mit dem externer elektronischen Datenverarbeitungssystem elektrisch verbindbar ist und darüber mit elektrischer Energie versorgt werden sowie Meßwerte zum Datenverarbeitungssystem übertragen kann. Die Umformer-Elektronik UE kann dafür ferner eine dem Anschließen der Umformer-Elektronik an die Zweileiter-Verbindung 2L anschließbare Zweileiter-Anschlußschaltung aufweisen, über die die Umformer-Elektronik UE die für deren Betrieb erforderliche elektrische Leistung von der vorbezeichneten Auswerte- und Versorgungseinheit bezieht, etwa inform eines von der Auswerte- und Versorgungseinheit via (4 mA bis 20 mA-) Stromschleife eingespeisten Versorgungsgleichstroms und einer damit korrespondierenden Klemmenspannung an einem Eingang der Zweileiter-Anschlußschaltung, und über die die Umformer-Elektronik im Betrieb generierte Meßdaten bzw. -werte an die Auswerte- und Versorgungseinheit übermittelt, beispielsweise durch (Last-)Modulation des Versorgungsgleichstromes.

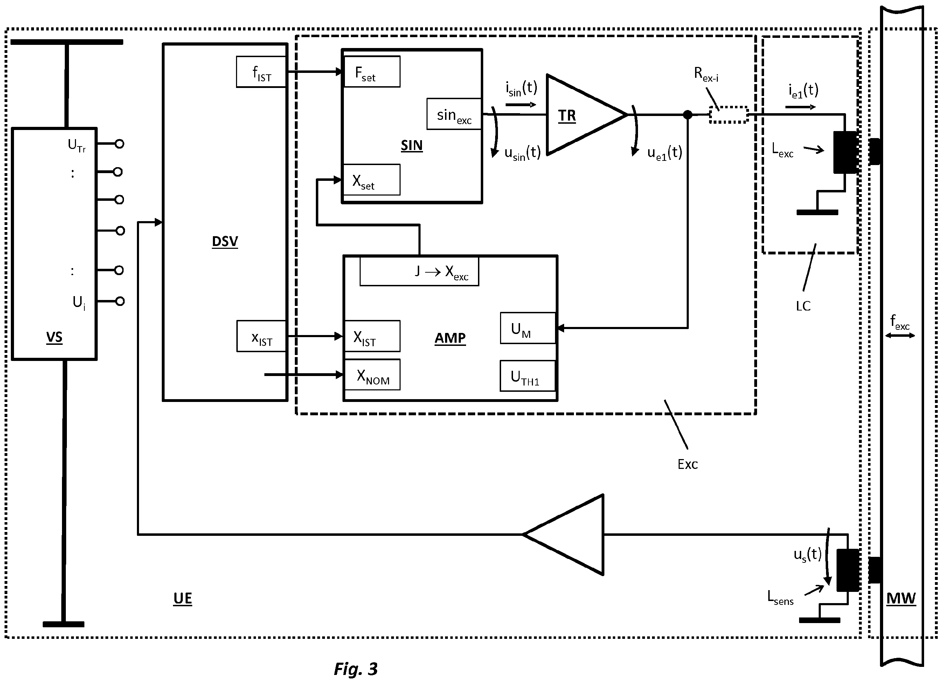

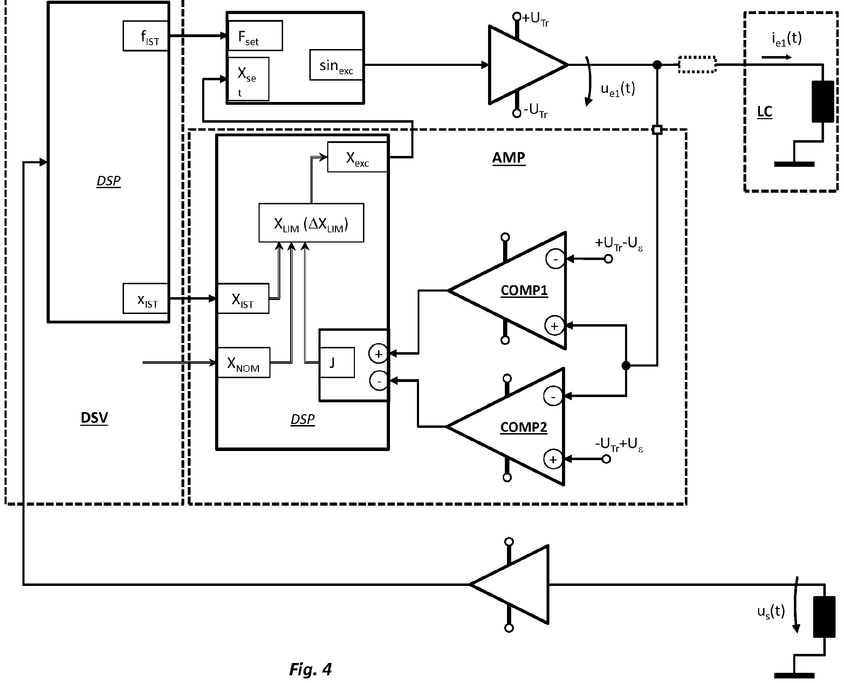

Zum Ansteuern des Meßwandlers weist die, beispielsweise auch eigensichere und/oder nominell mit einer maximalen Leistung von 1 W oder weniger betriebene, Umformer-Elektronik UE, wie in Fig. 2, 3 bzw. 4 schematisch nach Art eines Blockschaltbildes dargestellt, ferner eine, insb. nämlich dem Generieren des vorbezeichneten Treibersignals e1 bzw. dem Treiben des Aktors 41 dienliche, Treiberschaltung Exc auf. Nämliche Treiberschaltung Exc ist nach einer weiteren Ausgestaltung der Erfindung mit einer ferner in der Umformer-Elektronik UE vorgesehen - hier nämlich als ein Bestandteil des vorbezeichneten Aktors 41 eines physikalisch-elektrischen Meßwandlers ausgebildeten und/oder mittels wenigstens einer Spule $L_{exc}$ gebildeten - Lastschaltung LC elektrisch verbunden. Nach einer weiteren Ausgestaltung der Erfindung ist, wie auch in Fig. 3 bzw. 4 jeweils angedeutet, in der Lastschaltung ferner ein, insb. dem Begrenzen des Laststroms auf eine Eigensicherheit der Lastschaltung bzw. der damit gebildeten Umformer-Elektronik gewährleistende Stromstärke dienliches, Widerstandselement $R_{ex-i}$ vorgesehen.

Die Treiberschaltung Exc umfaßt, wie in Fig. 3 bzw. 4 schematisch dargestellt, einen, beispielsweise mittels eines digitalen Signalprozessors und/oder mittels eines Digital-zu-Analog-Wandlers gebildeten, Signalgenerator SIN mit einem Frequenzsteuereingang ($f_{set}$), mit einem Amplitudensteuereingang ($X_{set}$) und mit einen Signalausgang ($sin_{exc}$). Nämlicher Signalgenerator SIN ist dafür eingerichtet, an dessen Signalausgang ein zumindest zeitweise periodisches, beispielsweise auch zumindest zeitweise harmonisches, elektrisches Analogsignal $u_{sin}(t)$ mit einer durch einen am Frequenzsteuereingang anliegenden - digitalen oder ggf. auch analogen - Frequenzsteuerwert $f_{set}$ vorgegebenen Signalfrequenz ($f_{exc}$) und einer durch einen am Amplitudensteuereingang anliegenden - digitalen oder ggf. auch analogen - Amplitudensteuerwert $X_{set}$ vorgegebenen Spannungs- und/oder Stromamplitude auszugeben. Für den vorbezeichneten Fall, daß es sich bei dem Meßwandler MW um einen solchen vom Vibrationstyp handelt, kann nämlicher Frequenzsteuerwert $f_{SOLL}$ beispielsweise einer mittels der Treiberschaltung Exc anzuregenden, mithin als vorbezeichnete Nutzfrequenz dienlichen mechanischen Resonanzfrequenz des wenigstens einen Meßrohrs 10 entsprechen ($f_{set} \leftarrow f_{exc}$). Desweiteren weist die Treiberschaltung eine mittels einer, beispielsweise bipolaren, Gleichspannung $U_{Tr}$ betriebene Endstufe Tr mit einem, insb. hochohmigen und/oder einen Eingangswiderstand von mehr als 0.5 M$\Omega$ aufweisenden, Signaleingang und mit einem Lastausgang auf. Nämliche Gleichspannung $U_{Tr}$ kann zudem beispielsweise auch Betriebs- und/oder Referenzspannung des erwähnten Digital-zu-Analog-Wandlers des Signalgenerators SIN sein. Die Endstufe Tr ist im besonderen dafür eingerichtet, durch einen nämlichen Lastausgang involvierenden Stromkreis einen Laststrom $i_{e1}(t)$ mit einem von einer Signalspannung und/oder einem Signalstrom eines am Signaleingang anliegenden, beispielsweise bipolaren und/oder zumindest zeitweise periodischen, elektrischen Eingangssignals abhängigen Stromstärke zu treiben sowie an nämlichen Lastausgang eine Lastspannung $u_{e1}(t)$ mit einer von der Stromstärke des Laststroms $i_{e1}(t)$ abhängigen Spannungshöhe bereitzustellen. Anders ausgedrückt dient die Endstufe Tr also dazu, das an deren Signaleingang anliegende elektrisches Eingangs- oder auch Steuersignal in ein entsprechendes elektrisches Ausgangssignal (e₁) am Lastausgang zu wandeln, nämlich das Eingangssignal zu verstärken, so daß das damit korrespondierende, ggf. lediglich einer Amplitudenmodulation des Eingangssignals entsprechende, Ausgangssignal eine elektrische Leistung aufweist, die höher als eine elektrische Leistung des Eingangssignal ist bei einem ansonsten einem zeitlichen Verlauf des Eingangssignals im wesentlichen entsprechenden zeitlichen Verlauf. Wie aus der Fig. 3 ersichtlich ist bei der erfindungsgemäßen Treiberschaltung zudem der Signaleingang der Endstufe Tr mit dem Signalausgang des Signalgenerators SIN elektrisch verbunden, so daß die Stromstärke des von der Endstufe ausgegebenen Laststroms $i_e(t)$ von der Spannung $u_{sin}(t)$ und/oder dem Strom $i_{sin}(t)$ des vom Signalgenerator SIN ausgegebenen elektrischen Analogsignals abhängig ist bzw. daß das vom Signalgenerator ausgegebene Analogsignal mittels der Endstufe Tr verstärkt und in das am Lastausgang ausgegebene Ausgangssignal gewandelt wird. Für den in Fig. 3 bzw. 4 jeweils gezeigten Fall, daß der Lastausgang und der Aktor 41 des Meßwandlers miteinander elektrisch verbunden sind, kann nämliches am Lastausgang ausgegebenes Ausgangssignal dann somit als vorbezeichnetes Treibersignal e1 dienen. Dafür ist nach einer weiteren Ausgestaltung der Erfindung der Lastausgang der Endstufe mit der Lastschaltung LC elektrisch verbunden, derart, daß die Lastspannung über der Lastschaltung abfällt. Die Lastspannung $u_e(t)$ kann beispielsweise so ausgebildet sein, daß sie zumindest zeitweise einen periodischen Verlauf aufweist, insb. nämlich derart, daß die Lastspannung $u_e(t)$ über einen Zeitraum von wenigstens zwei Perioden mit einer vorgegebenen, nämlich dem Frequenzsteuerwert $f_{set}$ entsprechenden Frequenz ($f_{exc}$) ändert. Zum Einstellen der Stromstärke des Laststroms ie(t), beispielsweise nämlich deren Spitzenwert oder deren Effektivwert, bzw. der Spannungshöhe der Lastspannung $u_e(t)$, beispielsweise nämlich deren Spitzenwert oder deren Effektivwert, auf einen jeweils entsprechend vorgegebenen Sollwert bzw. zum Einstellen einer Amplitude des Treibersignals e1 weist die erfindungsgemäße Treiberschaltung Exc ferner eine - beispielsweise zumindest anteilig mittels des vorbezeichneten Mikroprozessors und/oder mittels des vorbezeichneten Signalprozessors gebildete - Amplitudensteuerung AMP mit einem - digitalen oder analogen - Amplitudeneingang und mit einem - digitalen oder analogen - Amplitudenausgang auf.

Die Amplitudensteuerung AMP der erfindungsgemäßen Treiberschaltung Exc ist zudem dafür eingerichtet, wiederkehrend eine Amplituden-Abweichung ΔX, nämlich eine - relative oder absolute - Abweichung zwischen einem am Amplitudeneingang anstehenden Amplituden-Istwert $X_{IST}$ und einem - hier eine nominelle, nämlich für einen normalen bzw. ungestörten Betrieb der Treiberschaltung Exc vorgegebene Amplitude repräsentierenden - Amplituden-Sollwert $X_{NOM}$ zu ermitteln ($|X_{IST} - X_{NOM}| \rightarrow \Delta X$, $|X_{IST} - X_{NOM}| / X_{NOM} \rightarrow \Delta X$). Nämlicher Amplituden-Sollwert $X_{NOM}$ kann beispielsweise direkt in der Amplitudensteuerung AMP vorgehalten sein und/oder, wie auch in Fig. 3 angedeutete von der Meß- und Steuerschaltung im Betrieb an die Amplitudensteuerung übermittelt werden. Darüberhinaus ist die Amplitudensteuerung AMP eingerichtet, wiederkehrend einen - hier eine momentan auszusteuernde bzw. mittels der Endstufe tatsächlich aussteuerbare Amplitude des Analogsignals, beispielsweise nämlich einer tatsächlich aussteuerbaren maximalen Spannung (Spitzenwert), repräsentierenden - Amplitudensteuerwert $X_{exc}$ zu ermitteln, beispielsweise nämlich basierend auf der vorbezeichneten Amplituden-Abweichung ΔX zu berechnen, sowie am Amplitudenausgang eine Amplitudensteuerfolge, nämlich eine Folge von zeitlich nacheinander berechnete Amplitudensteuerwerten auszugeben. Der Amplitudenausgang der Amplitudensteuerung wiederum ist mit dem Amplitudensteuereingang des Signalgenerators elektrisch verbunden, derart, daß die Spannungs- und/oder Stromamplitude des Analogsignals durch am Amplitudensteuereingang anliegende Amplitudensteuerwerte ($X_{set}$) der Amplitudensteuerfolge vorgegeben sind.

Bei dem erfindungsgemäßen Meßsystem kann der vorbezeichnete Meßwandler MW beispielsweise elektrisch und/oder elektro-magnetisch mit der Lastschaltung gekoppelt sein, derart, daß ein zeitlicher Verlauf des Meßsignals von einem zeitlichen Verlauf des Laststroms $i_e(t)$ und/oder der Lastspannung abhängig ist, etwa derart, daß eine Signalfrequenz des Meßsignals von einer Frequenz des Laststroms bzw. der Lastspannung $u_e(t)$ abhängig ist und/oder daß eine Signalamplitude des Meßsignals s1 von der Stromstärke des Laststroms $i_e(t)$ und/oder der Spannungshöhe $u_e(t)$ der Lastspannung abhängig ist. Nicht zuletzt für für den vorbezeichneten Fall, daß es sich bei dem Meßwandler um einen Meßwandler vom Vibrationstyp handelt, kann zudem ein mechanisch mit dem jeweiligen Meßrohr 10 verbundener Magnet mit einer in die Lastschaltung LC eingegliederten Spule $L_{exc}$ in Wechselwirkung stehen, nämlich mit dieser elektro-magnetisch gekoppelt sein. Bei nämlichem Magneten kann es sich beispielsweise um einen, insb. stabförmigen oder becherförmigen, Permanentmagneten handeln.

Zum Verarbeiten von vom Meßwandler gelieferten Meßsignalen weist die Umformer-Elektronik nach einer weiteren Ausgestaltung der Erfindung ferner eine Meß- und Steuerschaltung DSV auf. Nämliche Meß- und Steuerschaltung DSV ist, wie in Fig. 3 schematisch dargestellt, mit dem Meßwandler MW bzw. dessen Sensoranordnung 51 (bzw. 51, 52) elektrisch verbunden und im besonderen dafür eingerichtet, basierend auf dem wenigstens einen Meßsignal s1 des Meßwandlers MW im Betrieb die wenigstens eine Meßgröße, wie z.B. eine Massendurchflußrate, repräsentierende Meßwerte zu ermitteln und entsprechend auszugeben, beispielsweise in Form von Digitalwerten. Die vom Meßwandler generierten - beispielsweise nämlich jeweils als Schwingungsmeßsignal ausgebildeten - Meßsignale s1, s2, die im Falle eines Meßwandlers vom Vibrationstyp jeweils eine Signalkomponente mit einer momentanen, beispielsweise zwischen 100 Hz (= Hertz) und 2 kHz betragenden, Schwingfrequenz $f_{exc}$ des wenigstens einen schwingenden Meßrohrs entsprechende Signalfrequenz aufweisen, sind, wie auch in Fig. 2 gezeigt, der Umformer-Elektronik UE bzw. der darin vorgesehenen Meß- und Steuerschaltung DSV zugeführt, wo sie mittels einer entsprechenden Eingangsschaltung zunächst vorverarbeitet, beispielsweise nämlich vorverstärkt, gefiltert und digitalisiert werden, um anschließend geeignet ausgewertet werden zu können. Nach einer weiteren Ausgestaltung der Erfindung weist die Meß- und Steuerschaltung DSV dementsprechend wenigstens einen Meßsignaleingang auf und ist die Meßschaltung ferner dafür eingerichtet, von einem am Meßsignaleingang anliegenden Eingangssignal sowohl eine Signalfrequenz als auch eine Signalamplitude zu ermitteln. Darüberhinaus weist die Meß- und Steuerschaltung DSV, wie auch in Fig. 3 bzw. 4 jeweils angedeutet, einen - digitalen oder analogen - Frequenzausgang sowie einen - digitalen oder analogen - Amplitudenausgang auf. Zudem ist die Meß- und Steuerschaltung DSV auch dafür eingerichtet, am Amplitudenausgang eine Amplitudenfolge, nämlich eine Folge von anhand des Eingangssignals ermittelten, beispielsweise nämlich die Signalamplitude des Eingangssignals quantifizierenden und/oder digitalen, Amplitudenwerten $X_{set}$ und am Frequenzausgang eine Frequenzfolge, nämlich eine Folge von anhand des Eingangssignals ermittelten, beispielsweise eine für das Eingangssignal einzustellende Signalfrequenz quantifizierenden und/oder digitalen, Frequenzwerten $F_{IST}$ auszugeben. Nach einer weiteren Ausgestaltung der Erfindung ist ferner vorgesehen, daß der Frequenzausgang der Meß- und Steuerschaltung DSV mit dem Frequenzsteuereingang des Signalgenerators SIN der Treiberschaltung Exc elektrisch verbunden ist, derart, daß der an dessen Frequenzsteuereingang anliegende Frequenzsteuerwert $F_{set}$ einem Frequenzwert $f_{IST}$ der Frequenzfolge entspricht. Darüberhinaus kann der Amplitudenausgang der Meß- und Steuerschaltung DSV zudem mit dem Amplitudeneingang der Amplitudensteuerung AMP der Treiberschaltung Exc elektrisch verbunden sein, derart, daß der an deren Amplitudeneingang anstehende Amplituden-Istwert $X_{IST}$ einem Amplitudenwert $X_{IST}$ der Amplitudenfolge entspricht.

Nach einer weiteren Ausgestaltung der Erfindung ist der Meßwandler zudem mit dem Meßsignaleingang der Meß- und Steuerschaltung elektrisch gekoppelt, derart, daß die Meß- und Steuerschaltung das wenigstens eine Meßsignal empfängt und daß sowohl die Frequenz- als auch die Amplitudenfolge vom Meßsignal abhängig ist. Für den vorbezeichneten Fall, daß es sich bei dem Meßwandler um einen solchen vom Vibrationstyp handelt, können die Frequenzwerte der Frequenzfolge, wie bereits erwähnt, einer mittels des von der Treiberschaltung Exc generierten Treibersignals e1 jeweils einzustellenden Schwingungsfrequenz von Schwingungen des wenigstens einen Meßrohrs, beispielsweise nämlich einer anzuregenden Resonanzfrequenz des wenigstens einen Meßrohrs, entsprechen bzw. können die Amplitudenwerte der Amplitudenfolge einer mittels des Treibersignals jeweils einzustellenden Schwingungsamplitude von Schwingungen des wenigstens einen Meßrohrs entsprechen. Nach einer weiteren Ausgestaltung der Erfindung ist die Meß- und Steuerschaltung ferner eingerichtet, basierend auf dem Meßsignal die wenigstens eine physikalische Meßgröße repräsentierende - analoge und/oder digitale - Meßwerte zu ermitteln.

Nach einer weiteren Ausgestaltung der Erfindung ist die Meß- und Steuerschaltung DSV mittels eines in der Umformer-Elektronik UE vorgesehenen, beispielsweise mittels eines digitalen Signalprozessors DSP realisierten, Mikrocomputers und mittels in diesen entsprechend implementierter und darin ablaufender Programm-Codes realisiert. Die Programm-Codes können z.B. in einem nicht-flüchtigen Datenspeicher EEPROM des Mikrocomputers persistent gespeichert sein und beim Starten desselben in einen, z.B. im Mikrocomputer integrierten, flüchtigen Datenspeicher RAM geladen werden. Es versteht sich dabei praktisch von selbst, daß die Meßsignale, wie bereits angedeutet, für eine Verarbeitung im Mikrocomputer mittels entsprechender Analog-zu-digital-Wandler (A/D-Wandler) der Umformer-Elektronik ME in entsprechende Digitalsignale umzuwandeln sind, vgl. hierzu beispielsweise die eingangs erwähnten US-B 63 11 136 oder US-A 2011/0271756. Die Meß- und Steuerschaltung DSV kann außer mit dem Meßwandler im Betrieb beispielsweise zudem mit der Treiber-Schaltung Exc kommunizieren, beispielsweise nämlich um damit generierte Amplitudensteuerwerte ($X_{exc}$) bei der Berechnung der Meßwerte entsprechend zu berücksichtigen.

Die Treiberschaltung Exc und die vorbezeichnete Meß- und Steuerschaltung DSV sowie weitere, dem Betrieb des Meßsystems dienliche Elektronik-Komponenten der Umformer-Elektronik UE, wie etwa eine interne Energieversorgungsschaltung VS zum Bereitstellen interner Versorgungsgleichspannungen und/oder eine der Kommunikation mit einem übergeordneten Meßdatenverarbeitungssystem bzw. einem externen Feldbus dienliche Sende- und Empfangsschaltung COM, können - wie auch aus einer Zusammenschau der der Fig. 1 und 2 ohne weiteres ersichtlich - beispielsweise in einem entsprechenden, insb. schlag- und/oder auch explosionsfest und/oder hermetisch dicht ausgebildeten, Elektronikgehäuse 200 untergebracht sein. Zum Visualisieren von Meßsystem intern erzeugten Meßwerten und/oder gegebenenfalls Meßsystem intern generierten Statusmeldungen, wie etwa eine Fehlermeldung oder einen Alarm, vor Ort kann das Meßsystem desweiteren ein zumindest zeitweise mit der Meß- und Steuerschaltung kommunizierendes Anzeige- und Bedienelement HMI aufweisen, wie etwa ein in vorbezeichnetem Elektronikgehäuse 200 hinter einem darin entsprechend vorgesehenen Fenster plaziertes LCD-, OLED- oder TFT-Display sowie eine entsprechende Eingabetastatur und/oder ein Touchscreen. Das elektrische Anschließen des Meßwandlers MW an die Umformer-Elektronik UE kann mittels entsprechender Anschlußleitungen erfolgen, die aus dem Elektronik-Gehäuse 200, beispielsweise via Kabeldurchführung. Die Anschlußleitungen können dabei zumindest anteilig als elektrische, zumindest abschnittsweise in von einer elektrischen Isolierung umhüllte Leitungsdrähte ausgebildet sein, z.B. inform von "Twisted-pair"-Leitungen, Flachbandkabeln und/oder Koaxialkabeln. Alternativ oder in Ergänzung dazu können die Anschlußleitungen zumindest abschnittsweise auch mittels Leiterbahnen einer, insb. flexiblen, gegebenenfalls lackierten Leiterplatte gebildet sein.

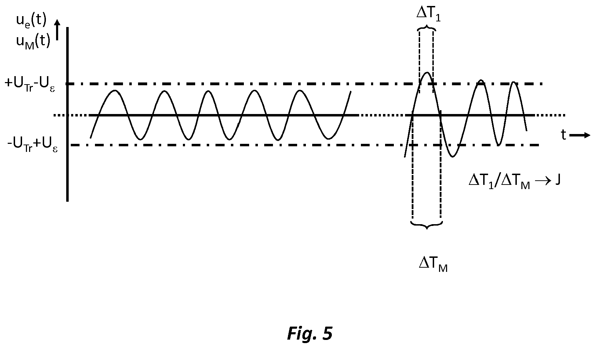

Wie eingangs erwähnt kann bei Meßsystemen der in Rede stehenden Art, nicht zuletzt auch bei Zweileiter-Feldgeräten bzw. vibronischen Meßsystemen, eine Meßgenauigkeit mit der die Meßwerte für die wenigstens eine Meßgröße ermittelt werden, davon abhängen, daß die Treiberschaltung innerhalb eines dafür spezifizierten Arbeitsbereichs operiert, mithin nicht oder allenfalls nur kurzzeitig überlastet wird. Im besonderer sind auch solche Überlastsituationen, bei denen Übersteuerung der Endstufe während der jeweiligen Messung auftritt, zu vermeiden um sicherstellen, daß der ausgegebene Laststrom $i_e(t)$ bzw. die ausgegebene Lastspannung $u_e(t)$ im Vergleich zum am Eingang liegenden Analogsignal nicht verzerrt ist, mithin um sicherzustellen, daß das so gebildete Treibersignal e1 bzw. eine dem entsprechende Anregung des Meßwandlers den in der Meß- und Steuerschaltung hinterlegten und an den Signalgenerator übermittelten Vorgaben tatsächlich entspricht. Beispielsweise ist ein dem in Fig. 5 gezeigten zeitlichen Verlauf entsprechender Verlauf der Lastspannung $u_e(t)$ zu vermieden oder sollte zumindest, wie auch in Fig. 5 angedeutet, allenfalls nur kurzzeitig auftreten gelassen werden. Zum Erfassen einer sich anbahnenden oder tatsächlich eingetretenen Überlastsituation der Treiberschaltung Exc, beispielsweise nämlich einer Übersteuerung der Endstufe Tr, weist die Amplitudensteuerung der erfindungsgemäßen Treiberschaltung ferner einen, insb. hochohmigen bzw. einen Eingangswiderstand von mehr als 0.5 M$\Omega$ (= Megaohm) aufweisenden, Spannungsmeßeingang ($U_M$) auf. Zudem ist die Amplitudensteuerung im besonderen auch dafür eingerichtet, wiederkehrend einen Indikatorwert J zu ermitteln, der signalisiert, ob ein Betrag $|u_M(t)| = U_M$ einer am Spannungsmeßeingang anliegenden Meßspannung $u_M(t)$ zu hoch ist, nämlich ob der Betrag $|u_M(t)| = U_M$ einen dafür vorgegebenen Schwellenwert $U_{TH1}$ überschritten hat $( U_M \overset{?}{>} U_{TH1} )$.

Nach einer weiteren Ausgestaltung der Erfindung ist die Amplitudensteuerung AMP ferner auch dafür eingerichtet, bei einem zu hohen Betrag $U_M$ der Meßspannung $U_M$ bzw. einen jeweiligen nächsten Amplitudensteuerwert jeweils so zu berechnen, daß nämlicher Amplitudensteuerwert kleiner ist als ein jeweils vorheriger Amplitudensteuerwert.

Nach einer anderen Ausgestaltung der Erfindung ist die Amplitudensteuerung zudem dafür eingerichtet, zu ermitteln, in welchem Maße die Meßspannung zu hoch ist bzw. ein Ausmaß, um das die Meßspannung zu hoch ist, zu quantifizieren, beispielsweise nämlich zu ermitteln um wieviel ein Betrag einer Spannungsamplitude der Meßspannung über dem Schwellenwert $U_{TH1}$ liegt und/oder für wie lange der Betrag der Meßspannung innerhalb eines vorgegeben Zeitintervalls über dem Schwellenwert $U_{TH1}$ liegt, bzw. ist die Amplitudensteuerung zudem dafür eingerichtet, den Indikatorwert J so zu ermitteln, daß dieser ein Ausmaß quantifiziert, um das die Meßspannung, mithin die Lastspannung $u_e(t)$ zu hoch ist. Beispielsweise kann, wie auch in Fig. 5 angedeutet, zwecks Ermittlung des Indikatorwertes J mittels der Amplitudensteuerung ein zeitlicher Anteil $\Delta T_1$ ermittelt werden, mit dem die Meßspannung $u_M(t)$ bzw. die Lastspannung $u_e(t)$ für ein, beispielsweise mit 20 ms (= Millisekunden) und/oder mit größer als eine Schwingungsperiode der vorbezeichneten Signalfrequenz $f_{exc}$, vorgegebenes - beispielsweise zurückliegendes bzw. jüngst vergangenes - Meßintervall $\Delta T_M$ insgesamt zu hoch ist bzw. gewesen ist, und kann basierend darauf der Indikatorwert J so von der Amplitudensteuerung AMP generiert werden, daß dieser nämlichen zeitlichen Anteil, beispielsweise relativ bzw. bezogen auf nämliches Meßintervall $\Delta T_M$ ($\Delta T_1/\Delta T_M \rightarrow J$), quantifiziert. Nach einer weiteren Ausgestaltung der Erfindung ist daher ferner vorgesehen, daß die Amplitudensteuerung AMP den Indikatorwert J basierend auf einer Bedingung J = $J_{max} \cdot \Delta T_1/\Delta T_M$ berechnet bzw. daß der von der Amplitudensteuerung ermittelte Indikatorwert nämliche Bedingung erfüllt, wobei $J_{max}$ einen vorab festgelegten maximal zulässigen, beispielsweise nämlich mit dem Schwellenwert $U_{TH1}$ korrespondierenden bzw. dazu äquivalenten Wert ($J_{max} \sim U_{TH1}$) für den Indikatorwert J repräsentiert. Das vorbezeichnete Meßintervall $\Delta T_M$ kann in vorteilhafter Weise ferner so bemessen sein, daß es eine Bedingung $\Delta T_M \geq f_{exc}^{-1}$, insb. auch eine Bedingung 20 · $f_{exc}^{-1} > \Delta T_M \geq f_{exc}^{-1}$, erfüllt.

Zwecks einer möglichst raschen Rückführung einer als überhöht detektierten Lastspannung in den für die Treiberschaltung eigentlich spezifizierten Arbeitsbereich kann die Amplitudensteuerung AMP ferner auch dafür eingerichtet sein, den jeweils nächsten, mithin kleinerer Amplitudensteuerwert in Abhängigkeit von dem ermittelten Ausmaß der Überhöhung der Meßspannung $u_M(t)$ zu berechnen, beispielsweise derart, daß eine Differenz zwischen dem nämlichem nächsten Amplitudensteuerwert und dem vorherigen Amplitudensteuerwert proportional zu einer Differenz zwischen dem Betrag der (momentan überhöhten) Meßspannung $u_M(t)$ und dem Schwellenwert $U_{TH1}$ ist. Nach einer weiteren Ausgestaltung der Erfindung ist die Amplitudensteuerung AMP daher dafür eingerichtet, wiederkehrend einen mit dem (jeweils aktuellen) Indikatorwert J gewichteten Amplituden-Sollwert $X_{LIM}$ ($X_{LIM}$ = J·$X_{NOM}$) und/oder eine mit dem Indikatorwert gewichtete Amplituden-Abweichung $\Delta X_{LIM}$ ($\Delta X_{LIM}$ = J·$\Delta X$) zu berechnen, derart, daß nämlicher gewichteter Amplituden-Sollwert $X_{LIM}$ bei zu hoher Meßspannung kleiner ist als der Amplituden-Sollwert $X_{NOM}$ bzw. daß nämliche gewichtete Amplituden-Abweichung $X_{LIM}$ bei zu hoher Meßspannung $u_M(t)$ kleiner ist als die Amplituden-Abweichung $\Delta X$. Für den vorbezeichneten Fall, daß mittels der Amplitudensteuerung AMP zunächst die gewichtete Amplituden-Abweichung $\Delta X_{LIM}$ ermittelt wird, kann die Amplitudensteuerung AMP ferner auch dafür eingerichtet sein, die Amplitudensteuerwerte basierend auf der nämlicher gewichteten Amplituden-Abweichung $\Delta X_{LIM}$ zu berechnen. Zwecks der Berechnung der Amplitudensteuerwerte - sei es basierend auf der Amplituden-Abweichung $\Delta X$ und dem Indikatorwert J als Eingangsgrößen oder der bereits gewichteten Amplituden-Abweichung $\Delta X_{LIM}$ - kann in der Amplitudensteuerung AMP ferner ein entsprechender (Digital-)Regler, beispielsweise mit zumindest anteilig proportionalem und/oder zumindest anteiligem integrierendem Reglerverhalten (P-Regler, I-Regler bzw. PI-Regler), implementiert sein.

Nach einer weiteren Ausgestaltung der Erfindung ist die Amplitudensteuerung ferner umgekehrt auch dafür eingerichtet, den Indikatorwert so zu ermitteln, daß dieser signalisiert, ob bzw. ggf. daß der Betrag der am Spannungsmeßeingang anliegenden Meßspannung zu niedrig ist, nämlich ob der Betrag zumindest den Schwellenwert $U_{TH1}$ oder ggf. auch einen entsprechend vorgegebenen weiteren - nämlich im Vergleich zum (ersten) Schwellenwert $U_{TH1}$ niedriger - (zweiten) Schwellenwert $U_{TH2}$ unterschritten hat. Alternativ oder in Ergänzung kann die Amplitudensteuerung zudem auch dafür eingerichtet sein, Amplitudensteuerwerte so zu berechnen, daß bei einem zu niedrigen Betrag $U_M$ der Meßspannung $u_M(t)$, mithin der Lastspannung $u_e(t)$ aufeinanderfolgende Amplitudensteuerwerte der Amplitudensteuerfolge, beispielsweise nämlich sukzessive, erhöht werden.

Der vorbezeichnete Schwellenwert $U_{TH1}$ bzw. der ggf. ebenfalls benötigte Schwellenwert $U_{TH2}$ kann beispielsweise in der Amplitudensteuerung vorgehalten sein, beispielsweise in Form eines digitalen Vorgabewertes, oder, wie auch in Fig. 3 bzw. 4 angedeutet, innerhalb der Amplitudensteuerung mittels Komparatoren anhand von an entsprechenden Referenzspannungseingängen entsprechend angelegten Referenzspannungen (+$U_{TR}$ -$U_\varepsilon$) bzw. (- $U_{TR}$ +$U_\varepsilon$ in Form eines analogen Vorgabewertes $U_{TH1}$ = |+$U_{TR}$ -$U_\varepsilon$| = |-$U_{TR}$ +$U_\varepsilon$| generiert werden. Darüberhinaus ist die Amplitudensteuerung AMP ferner eingerichtet unter Verwendung nämlichen Indikatorwerts J einen, insb. dem Verringern bzw. Minimieren der Amplituden-Abweichung dienlichen und/oder digitalen, Amplitudensteuerwert zu berechnen, derart, daß bei einem zu hohen Betrag $U_M$ der Meßspannung $u_M(t)$ aufeinanderfolgende Amplitudensteuerwerte $X_{exc}$ der Amplitudensteuerfolge, ggf. auch trotz einer fortwährend zu hohen bzw. weiterhin zunehmenden Amplituden-Abweichung $\Delta X$, verringert werden, beispielsweise sukzessive, ggf. auch mit einer vorgegebenen bzw. konstanten Schrittweite. Wie in Fig. 3 bzw. 4 dargestellt, ist nach einer weiteren Ausgestaltung der Erfindung der Lastausgang der Endstufe Tr mit dem Spannungsmeßeingang der Amplitudensteuerung AMP elektrisch verbunden, derart, daß die Lastspannung $u_e(t)$ am Spannungsmeßeingang der Amplitudensteuerung anliegt, mithin als hinsichtlich des Betrages zu überwachende Meßspannung $u_M(t)$ dient (|$u_e(t)$| → $U_M$). Durch Auswahl eines geeigneten, beispielsweise nämlich auf eine Dynamik der Treiberschaltung Exc bzw. eines mittels des Signalgenerators SIN, der Endstufe Tr sowie der Amplitudensteuerung AMP gebildeten Spannungsreglers für die Lastspannung $u_e(t)$ abgestimmten, Schwellenwerts $U_{TR1}$ = |+$U_{TR}$ -$U_\varepsilon$| = |-$U_{TR}$ +$U_\varepsilon$| bzw. durch entsprechende Auswahl der diesem ggf. entsprechenden Referenzspannungen |+$U_{TR}$ -$U_\varepsilon$|, |-$U_{TR}$ +$U_\varepsilon$| kann auf sehr einfache, gleichwohl effektive Weise sichergestellt werden, daß die Endstufe Tr bzw. die damit gebildete Treiberschaltung Exc weitestgehend nur innerhalb eines stabilen Arbeitsbereichs betrieben ist bzw. daß die Endstufe Tr allenfalls nur sehr kurzzeitig übersteuert.

Nach einer weiteren Ausgestaltung der Erfindung weist die Amplitudensteuerung zur Ermittlung des Indikatorwerts J einen ersten Komparator COMP1 mit einem nicht-invertierenden Spannungseingang ("+") und mit einem invertierenden Spannungseingang ("-") auf, wobei - wie auch in Fig. 4 dargestellt - der Spannungsmeßeingang der Amplitudensteuerung mittels nämlichen nicht-invertierenden Spannungseingangs gebildet ist, und wobei nämlichem invertierenden Spannungseingang eine erste Referenzspannung (+ $U_{TR}$ - $U_\varepsilon$) angelegt ist. Darüberhinaus kann die Amplitudensteuerung zudem einen zweiten Komparator COMP2 mit einem nicht-invertierenden Spannungseingang und mit einem invertierenden Spannungseingang aufweisen, wobei der Spannungsmeßeingang der Amplitudensteuerung auch mittels nämlichen invertierenden Spannungseingangs gebildet ist und wobei nämlichem nicht-invertierenden Spannungseingang eine von der ersten Referenzspannung (+$U_{TR}$ -$U_\varepsilon$) abweichende zweite Referenzspannung (-$U_{TR}$ +$U_\varepsilon$) angelegt ist.

**Patentansprüche**

1. Treiberschaltung, umfassend:

    - einen Signalgenerator (SIN)

        -- mit einem Frequenzsteuereingang ($f_{set}$),
        -- mit einem Amplitudensteuereingang ($X_{set}$)
        -- und mit einem Signalausgang ($sin_{exc}$);

    - eine Endstufe (Tr)

-- mit einem Signaleingang

-- und mit einem Lastausgang;

- sowie eine Amplitudensteuerung (AMP)

-- mit einem Amplitudeneingang,

-- mit einem Amplitudenausgang

-- und mit einem Spannungsmeßeingang;

-- wobei der Signalgenerator (SIN) dafür eingerichtet ist, an dessen Signalausgang ($\text{sin}_{exc}$) ein zumindest zeitweise periodisches elektrisches Analogsignal, $u_{sin}(t)$, mit einer durch einen am Frequenzsteuereingang anliegenden Frequenzsteuerwert ($F_{set}$) vorgegebenen Signalfrequenz ($f_{exc}$) und einer durch einen am Amplitudensteuereingang anliegenden Amplitudensteuerwert ($X_{set}$) vorgegebenen Spannungs- und/oder Stromamplitude auszugeben;

-- wobei die Endstufe (Tr) dafür eingerichtet ist, durch einen nämlichen Lastausgang involvierenden Stromkreis einen Laststrom, $i_{e1}(t)$, mit einem von einer Signalspannung und/oder einem Signalstrom eines am Signaleingang anliegenden elektrischen Eingangssignals abhängigen Stromstärke zu treiben sowie an nämlichem Lastausgang eine Lastspannung, $u_{e1}(t)$, mit einer von der Stromstärke des Laststroms, $i_{e1}(t)$, abhängigen Spannungshöhe bereitzustellen;

-- wobei die Amplitudensteuerung (AMP) dafür eingerichtet ist,

-- wiederkehrend eine Amplituden-Abweichung ($\Delta X$), nämlich eine Abweichung zwischen einem am Amplitudeneingang anstehenden Amplituden-Istwert ($X_{IST}$) und einem Amplituden-Sollwert ($X_{NOM}$) zu ermitteln,

-- wiederkehrend einen Indikatorwert (J) zu ermitteln, der signalisiert, ob ein Betrag ($U_M$) einer am Spannungsmeßeingang anliegenden Meßspannung, $u_M(t)$, zu hoch ist, nämlich ob der Betrag ($U_M$) einen Schwellenwert ($U_{TH1}$) überschritten hat, und unter Verwendung nämlichen Indikatorwerts (J) einen Amplitudensteuerwert ($X_{exc}$) zu ermitteln, derart, daß bei einem zu hohen Betrag der Meßspannung, $u_M(t)$, und/oder einem einen zu hohen Betrag der Meßspannung, $u_M(t)$, signalisierenden Indikatorwert (J) aufeinanderfolgende Amplitudensteuerwerte der Amplitudensteuerfolge verringert werden;

-- sowie am Amplitudenausgang eine Amplitudensteuerfolge, nämlich eine Folge von zeitlich nacheinander berechnete Amplitudensteuerwerten auszugeben;

- wobei der Signalausgang ($\text{sin}_{exc}$) des Signalgenerators (SIN) mit dem Signaleingang der Endstufe (Tr) und der Lastausgang der Endstufe mit dem Spannungsmeßeingang der Amplitudensteuerung (AMP) elektrisch verbunden sind, derart,

-- daß die Stromstärke des von der Endstufe (Tr) ausgegebenen Laststroms, $i_{e1}(t)$, von der Spannung und/oder dem Strom des vom Signalgenerator (SIN) ausgegebenen elektrischen Analogsignals, $u_{sin}(t)$, abhängig ist

-- und daß die Lastspannung, $u_e(t)$, am Spannungsmeßeingang der Amplitudensteuerung (AMP) anliegt;

- und wobei der Amplitudenausgang der Amplitudensteuerung (AMP) mit dem Amplitudensteuereingang ($X_{set}$) des Signalgenerators (SIN) elektrisch verbunden ist, derart, daß die Spannungs- und/oder Stromamplitude des Analogsignals, $u_{sin}(t)$, durch am Amplitudensteuereingang ($X_{set}$) anliegende Amplitudensteuerwerte der Amplitudensteuerfolge vorgegeben sind.

2. Treiberschaltung nach einem der vorherigen Ansprüche,

- wobei die Amplitudensteuerung (AMP) dafür eingerichtet ist, einen zeitlichen Anteil, mit dem die Meßspannung, $u_M(t)$, für ein vorgegebenes Meßintervall ($\Delta T_M$) insgesamt zu hoch ist, zu ermitteln;

- und wobei die Amplitudensteuerung (AMP) dafür eingerichtet ist, den Indikatorwert (J) so zu ermitteln, daß dieser nämlichen zeitlichen Anteil, insb. relativ bzw. bezogen auf nämliches Meßintervall ($\Delta T_M$), quantifiziert.

3. Treiberschaltung nach einem der vorherigen Ansprüche, wobei die Lastspannung, $u_e(t)$, mithin die am Spannungsmeßeingang der Amplitudensteuerung (AMP) anliegende Meßspannung, $u_M(t)$, zumindest zeitweise einen periodischen Verlauf aufweisen, insb. derart, daß die Lastspannung, $u_e(t)$, bzw. die Meßspannung, $u_M(t)$, über einen Zeitraum von wenigstens zwei Perioden mit einer vorgegebenen, nämlich dem Frequenzsteuerwert ($f_{set}$) entsprechenden Frequenz ($f_{exc}$) ändert.

4. Treiberschaltung nach einem der vorherigen Ansprüche,

- wobei die Amplitudensteuerung (AMP) eingerichtet ist, bei einem zu hohen Betrag ($U_M$) der Meßspannung, $u_M(t)$, einen jeweiligen nächsten Amplitudensteuerwert jeweils so zu berechnen, daß nämlicher Amplitudensteuerwert kleiner ist als ein jeweils vorheriger Amplitudensteuerwert; und/oder

- wobei die Amplitudensteuerung (AMP) eingerichtet ist, den Indikatorwert (J) so zu ermitteln, daß dieser signalisiert, ob der Betrag $(U_M)$ der am Spannungsmeßeingang anliegenden Meßspannung, $u_M(t)$, zu niedrig ist, nämlich ob der Betrag zumindest den Schwellenwert $(U_{TH1})$ unterschritten hat; und/oder

- wobei die Amplitudensteuerung (AMP) eingerichtet ist, Amplitudensteuerwerte so zu berechnen, daß bei einem zu niedrigen Betrag $(U_M)$ der Meßspannung, $u_M(t)$, aufeinanderfolgende Amplitudensteuerwerte der Amplitudensteuerfolge, insb. sukzessive, erhöht werden; und/oder

- wobei die Amplitudensteuerung (AMP) eingerichtet ist, eine mit dem Indikatorwert (J) gewichtete Amplituden-Abweichung $(\Delta X_{LIM})$ zu berechnen, derart, daß nämliche gewichtete Amplituden-Abweichung $(\Delta X_{LIM})$ bei zu hoher Meßspannung, $u_M(t)$, kleiner ist als die Amplituden-Abweichung $(\Delta X)$; und/oder

- wobei die Amplitudensteuerung (AMP) eingerichtet ist, einen mit dem Indikatorwert (J) gewichteten Amplituden-Sollwert $(X_{LIM})$ zu berechnen, derart, daß nämlicher gewichteter Amplituden-Sollwert $(X_{LIM})$ bei zu hoher Meßspannung, $u_M(t)$, kleiner ist als der Amplituden-Sollwert $(X_{NOM})$; und/oder

- wobei die Amplitudensteuerung (AMP) dafür eingerichtet ist, zu ermitteln, in welchem Maße die Meßspannung, $u_M(t)$, zu hoch ist bzw. ein Ausmaß, um das die Meßspannung, $u_M(t)$, zu hoch ist, zu quantifizieren; und/oder

- wobei die Amplitudensteuerung (AMP) dafür eingerichtet ist, den Indikatorwert (J) so zu ermitteln, daß nämlicher Indikatorwert (J) ein Ausmaß, um das die Meßspannung, $u_M(t)$, zu hoch ist, quantifiziert.

5. Treiberschaltung nach einem der vorherigen Ansprüche, wobei die Amplitudensteuerung (AMP) einen ersten Komparator (COMP1) mit einem nicht-invertierenden Spannungseingang und mit einem invertierenden Spannungseingang aufweist, wobei der Spannungsmeßeingang der Amplitudensteuerung (AMP) mittels nämlichen nicht-invertierenden Spannungseingangs gebildet ist, und wobei nämlichem invertierenden Spannungseingang eine erste Referenzspannung $(+U_{TR}-U_\varepsilon)$ angelegt ist.

6. Treiberschaltung nach dem vorherigen Anspruch, wobei die Amplitudensteuerung (AMP) einen zweiten Komparator (COMP2) mit einem nicht-invertierenden Spannungseingang und mit einem invertierenden Spannungseingang aufweist, wobei der Spannungsmeßeingang der Amplitudensteuerung (AMP) mittels nämlichen invertierenden Spannungseingangs gebildet ist und wobei nämlichem nicht-invertierenden Spannungseingang eine von der ersten Referenzspannung $(+U_{TR}-U_\varepsilon)$ abweichende zweite Referenzspannung $(-U_{TR}+U_\varepsilon)$ angelegt ist.

7. Umformer-Elektronik, umfassend:

- eine Treiberschaltung (Exc) nach einem der vorherigen Ansprüche;
- sowie eine, insb. als ein Bestandteil eines elektro-mechanischen oder elektro-magnetischen Aktors eines physikalisch-elektrischen Meßwandlers ausgebildete und/oder mittels wenigstens einer Spule gebildete, Lastschaltung (LC);
- wobei der Lastausgang der Endstufe (Tr) sowohl mit dem Spannungsmeßeingang der Amplitudensteuerung (AMP) als auch mit der Lastschaltung (LC) elektrisch verbunden ist, derart, daß die Lastspannung, $u_{e1}(t)$, sowohl am Spannungsmeßeingang der Amplitudensteuerung (AMP) anliegt als auch über der Lastschaltung (LC) abfällt.

8. Umformer-Elektronik gemäß dem vorherigen Anspruch,

- wobei die Lastschaltung (LC) eine Spule $(L_{exc})$ aufweist; und/oder
- wobei die Lastschaltung (LC) ein, insb. dem Begrenzen des Laststroms, $i_{e1}(t)$, auf eine Eigensicherheit der Lastschaltung (LC) bzw. der Umformer-Elektronik gewährleistende Stromstärke dienliches, Widerstandselement $(R_{ex-i})$ aufweist.

9. Umformer-Elektronik nach einem der Ansprüche 7 bis 8, weiters umfassend eine Zweileiter-Anschlußschaltung zum Anschließen der Umformer-Elektronik an eine davon entfernte Auswerte- und Versorgungseinheit.

10. Umformer-Elektronik nach dem vorherigen Anspruch, wobei die Zweileiter-Anschlußschaltung dafür eingerichtet ist, für den Betrieb der Treiberschaltung erforderliche elektrische Leistung von der Auswerte- und Versorgungseinheit, insb. via (4 mA bis 20 mA-) Stromschleife, zu beziehen.

11. Umformer-Elektronik gemäß einem der Ansprüche 7 bis 10, weiters umfassend: eine Meß- und Steuerschaltung (DSV)

- mit einem Meßsignaleingang,

- mit einem, insb. digitalen, Frequenzausgang
- und mit einem, insb. digitalen, Amplitudenausgang,

-- wobei die Meßschaltung (DSV) dafür eingerichtet ist, von einem am Meßsignaleingang anliegenden Eingangssignal sowohl eine Signalfrequenz als auch eine Signalamplitude zu ermitteln,

-- und wobei die Meß- und Steuerschaltung (DSV) dafür eingerichtet ist, am Amplitudenausgang eine Amplitudenfolge, nämlich eine Folge von anhand des Eingangssignals ermittelten, insb. die Signalamplitude des Eingangssignals quantifizierenden und/oder digitalen, Amplitudenwerten ($x_{ist}$) und am Frequenzausgang eine Frequenzfolge, nämlich eine Folge von anhand des Eingangssignals ermittelten, insb. eine für das Eingangssignal einzustellende Signalfrequenz quantifizierende und/oder digitalen, Frequenzwerten ($f_{IST}$) auszugeben.

12. Umformer-Elektronik nach dem vorherigen Anspruch und Anspruch 9 oder 10, wobei die Zweileiter-Anschlußschaltung dafür eingerichtet ist, mittels der Meß- und Steuerschaltung generierte Meßdaten an die Auswerte- und Versorgungseinheit, insb. durch Modulation eines in der Zweileiter-Anschlußschaltung fließenden und/oder der Bereitstellung von elektrischer Leistung für die Treiberschaltung (Exc) und/oder die Meß- und Steuerschaltung (DSV) dienenden Stromes, zu übermitteln.

13. Meßsystem, umfassend:

- eine Umformer-Elektronik (UE) gemäß dem vorherigen Anspruch;
- sowie einen an nämliche Umformer-Elektronik (UE) elektrisch angeschlossenen Meßwandler (MW), der dafür eingerichtet ist, wenigstens eine physikalische Meßgröße, insb. einer Massendurchflußrate und/oder einer Dichte und/oder einer Viskosität eines in einer Rohrleitung geführten Fluids oder eines Füllstands eines in einem Behälter vorgehaltenen schüttfähigen Mediums, zu erfassen und in ein korrespondierendes Meßsignal (s1) zu wandeln, derart, daß das Meßsignal (s1) einer Änderung nämlicher physikalischen Meßgröße mit einer Änderung einer wenigstens eines Signalparameters, insb. einer Signalamplitude, einer Signalfrequenz und/oder eines Phasenwinkels, folgt.

14. Meßsystem nach dem vorherigen Anspruch,

- wobei der Frequenzausgang der Meß- und Steuerschaltung (DSV) mit dem Frequenzsteuereingang des Signalgenerators (SIN) der Treiberschaltung (Tr) elektrisch verbunden ist, derart, daß der an dessen Frequenzsteuereingang anliegende Frequenzsteuerwert einem Frequenzwert der Frequenzfolge entspricht;
- wobei der Amplitudenausgang der Meß- und Steuerschaltung (DSV) mit dem Amplitudeneingang der Amplitudensteuerung (AMP) der Treiberschaltung (Tr) elektrisch verbunden ist, derart, daß der an deren Amplitudeneingang anstehende Amplituden-Istwert einem Amplitudenwert der Amplitudenfolge entspricht;
- und wobei der Meßwandler (MW) mit dem Meßsignaleingang der Meß- und Steuerschaltung (DSV) elektrisch gekoppelt ist, derart, daß die Meß- und Steuerschaltung (DSV) das wenigstens eine Meßsignal (s1) empfängt und daß sowohl die Frequenz- als auch die Amplitudenfolge vom Meßsignal (s1) abhängig ist.

15. Meßsystem nach dem vorherigen Anspruch,

- wobei Meß- und Steuerschaltung (DSV) dafür eingerichtet ist, basierend auf dem Meßsignal (s1) die wenigstens eine physikalische Meßgröße repräsentierende, insb. digitale, Meßwerte zu ermitteln; und/oder
- wobei der Meßwandler (MW) mit der Lastschaltung elektrisch und/oder elektro-magnetisch gekoppelt ist, derart, daß ein zeitlicher Verlauf des Meßsignals (s1) von einem zeitlichen Verlauf des Laststroms, $i_{e1}(t)$, und/oder der Lastspannung, $u_{e1}(t)$, abhängig ist; insb. derart, daß eine Signalfrequenz des Meßsignals (s1) von einer Frequenz des Laststroms bzw. der Lastspannung abhängig ist und/oder derart, daß eine Signalamplitude des Meßsignals von der Stromstärke des Laststroms und/oder der Spannungshöhe der Lastspannung abhängig ist; und/oder
- wobei der Meßwandler (MW) ein, insb. nämlich mit einem mit einer Spule der Lastschaltung wechselwirkenden Magneten mechanisch verbundenes, Meßrohr aufweist, das dafür eingerichtet ist, einen fluiden Meßstoff zu führen, insb. nämlich von einem fluiden Meßstoff durchströmt und währenddessen vibrieren gelassen zu werden; und/oder
- wobei der Meßwandler (MW) einen, insb. stabförmigen oder becherförmigen, Permanentmagneten aufweist, der mit einer in die Lastschaltung (LC) eingegliederten Spule ($L_{exc}$) wechselwirkt.

16. Meßsystem nach einem der Ansprüche 13 bis 15, weiters umfassend: eine, insb. von der Umformer-Elektronik entfernte, Auswerte- und Versorgungseinheit, wobei die Umformer-Elektronik an nämliche Auswerte- und Versorgungseinheit angeschlossen ist.

17. Meßsystem nach dem vorherigen Anspruch, wobei die Umformer-Elektronik für den Betrieb der Treiberschaltung erforderliche elektrische Leistung von der Meß- und Versorgungseinheit bezieht.

18. Meßsystem nach dem vorherigen Anspruch, wobei die Umformer-Elektronik mittels der Meß- und Steuerschaltung generierte Meßdaten, insb. jeweils eine Massendurchflußrate eines in einer Rohrleitung strömenden Mediums repräsentierende Massendurchfluß-Meßwerte, jeweils eine Dichte eines Mediums repräsentierende Dichte-Meßwerte, oder jeweils eine Viskosität eines Mediums repräsentierende Viskositäts-Meßwerte, an die Auswerte- und Versorgungseinheit, insb. durch Modulation eines in einer in der Umformer-Elektronik vorgesehene Zweileiter-Anschlußschaltung fließenden Stromes, übermittelt.

**Claims**

1. Driver circuit, comprising:

   - a signal generator (SIN)

     -- with a frequency control input ($f_{set}$),
     -- with an amplitude control input ($X_{set}$)
     -- and with a signal output ($sin_{exc}$);

   - a final stage (Tr)

     -- with a signal input
     -- and with a load output;

   - as well as an amplitude controller (AMP)

     -- with an amplitude input,
     -- with an amplitude output,
     -- and with a voltage measuring input;
     -- wherein the signal generator (SIN) is configured to output, at its signal output ($sin_{exc}$), an electrical analog signal, $u_{sin}(t)$, which is at least temporarily periodical, with a signal frequency ($f_{exc}$) predefined by a frequency control value ($F_{set}$) present at the frequency control input and with a voltage and/or current amplitude predefined by an amplitude control value ($X_{set}$) present at the amplitude control input;
     -- wherein the final stage (Tr) is designed to drive a load current, $i_{e1}(t)$, using a circuit involving said load output, with a current strength that depends on a signal voltage and/or a signal current of an electrical input signal present at the signal input, and to provide a load voltage, $u_{e1}(t)$, with a voltage level that depends on the current strength of the load current, $i_{e1}(t)$, at said load output;
   -- wherein the amplitude controller (AMP) is designed to
   -- determine in a recurrent manner an amplitude deviation ($\Delta X$), particularly a deviation between an amplitude actual value ($X_{IST}$) present at the amplitude input and an amplitude target value ($X_{NOM}$),
   -- determine in a recurrent manner an indicator value (J), which signals whether a value ($U_M$) of a measured voltage, $u_M(t)$, present at the voltage measuring input, is too high, particularly whether the value ($U_M$) has exceeded a threshold ($U_{TH1}$) and, using said indicator value (J), to determine an amplitude control value ($X_{exc}$) in such a way that if the value of the measured voltage, $u_M(t)$, is too high and/or the indicator value (J) signals an excessively high measured voltage, $u_M(t)$, consecutive amplitude control values of the amplitude control sequence are reduced;
   -- and to output, at the amplitude output, an amplitude control sequence, particularly a sequence of amplitude control values calculated consecutively over time;

   - wherein the signal output ($sin_{exc}$) of the signal generator (SIN) is connected electrically to the signal input of the final stage (Tr) and the load output of the final stage to the voltage measuring input of the amplitude controller (AMP), in such a way that

     -- the current strength of the load current, $i_{e1}(t)$, output by the final stage (Tr), depends on the voltage and/or the current of the electrical analog signal, $u_{sin}(t)$, output by the signal generator (SIN)
     -- and in such a way that the load voltage, $u_e(t)$, is present at the voltage measuring input of the amplitude controller (AMP);

   - and wherein the amplitude output of the amplitude controller (AMP) is connected electrically to the amplitude control input ($X_{set}$) of the signal generator (SIN), in such a way that the voltage amplitude and/or current amplitude of the analog signal, $u_{sin}(t)$, is predefined by amplitude control values - present at the amplitude control input ($X_{set}$) - of the amplitude control sequence.

2. Driver circuit as claimed in one of the previous claims,

- wherein the amplitude controller (AMP) is designed to determine a time component during which the measured voltage, $u_M(t)$, is too high overall for a predefined measurement interval ($\Delta T_M$);
- and wherein the amplitude controller (AMP) is designed to determine the indicator value (J) in such a way that this value quantifies said time component, particularly in relation to said measurement interval ($\Delta T_M$).

3. Driver circuit as claimed in one of the previous claims, wherein the load voltage, $u_e(t)$, and thus the measured voltage, $u_M(t)$, present at the voltage measuring input of the amplitude controller (AMP), presents at least temporarily a periodic pattern, particularly in such a way that the load voltage, $u_e(t)$, or the measured voltage, $u_M(t)$ varies over a period of at least two periods at a predefined frequency ($f_{exc}$) corresponding to said frequency control value (fset).

4. Driver circuit as claimed in one of the previous claims,

- wherein, if the value ($U_M$) of the measured voltage, $u_M(t)$, is too high, the amplitude controller (AMP) is configured to calculate, in each case, a subsequent amplitude control value in such a way that said amplitude control value is less than a preceding amplitude control value in each case; and/or
- wherein the amplitude controller (AMP) is configured to determine the indicator value (J) in such a way that this value signals whether the value ($U_M$) of the measured voltage, $u_M(t)$, applied at the voltage measuring input, is too low, particularly whether the value has at least dropped below the threshold ($U_{TH1}$); and/or
- wherein the amplitude controller (AMP) is configured to calculate amplitude control values in such a way that if the value ($U_M$) of the measured voltage, $u_M(t)$, is too low, consecutive amplitude control values of the amplitude control sequence are increased, particularly successively; and/or
- wherein the amplitude controller (AMP) is configured to calculate an amplitude deviation ($\Delta X_{LIM}$) weighted with the indicator value (J) in such a way that said weighted amplitude deviation ($\Delta X_{LIM}$) is lower than the amplitude deviation ($\Delta X$) if the measured voltage, $u_M(t)$, is too high; and/or
- wherein the amplitude controller (AMP) is configured to calculate an amplitude target value ($X_{LIM}$) weighted with the indicator value (J) in such a way that said weighted amplitude target value ($X_{LIM}$) is lower than the amplitude target value ($X_{NOM}$) if the measured voltage, $u_M(t)$, is too high; and/or

- wherein the amplitude controller (AMP) is configured to determine the extent to which the measured voltage, $u_M(t)$, is too high, or to quantify a degree by which the measured voltage, $u_M(t)$, is too high; and/or
- wherein the amplitude controller (AMP) is configured to determine the indicator value (J) in such a way that said indicator value (J) quantifies a degree by which the measured voltage, $u_M(t)$, is too high.

5. Driver circuit as claimed in one of the previous claims, wherein the amplitude controller (AMP) comprises a first comparator (COMP1) with a non-inverting voltage input and with an inverting voltage input, wherein the voltage measuring input of the amplitude controller (AMP) is formed by said non-inverting voltage input, and wherein a first reference voltage ($+U_{TR}-U_\varepsilon$) is applied to said inverting voltage input.

6. Driver circuit as claimed in the previous claim, wherein the amplitude controller (AMP) comprises a second comparator (COMP2) with a non-inverting voltage input and with an inverting voltage input, wherein the voltage measuring input of the amplitude controller (AMP) is formed by said inverting voltage input, and wherein a second reference voltage ($-U_{TR}-U_\varepsilon$), which is different from the first reference voltage ($+U_{TR}-U_\varepsilon$), is applied to said non-inverting voltage input.

7. Transmitter electronics unit, comprising:

- a driver circuit (Exc) as claimed in one of the previous claims;
- as well as a load circuit (LC), particularly designed as a component of an electromechanical or electromagnetic actor of a physical-electrical transducer and/or formed by at least one coil;
- wherein the load output of the final stage (Tr) is connected electrically to both the voltage measuring input of the amplitude controller (AMP) and to the load circuit (LC) in such a way that the load voltage, $u_{e1}(t)$ is both present at the voltage measuring input of the amplitude controller (AMP) and also drops over the load circuit (LC).

8. Transmitter electronics unit as claimed in the previous claim,

- wherein the load circuit (LC) comprises a coil ($L_{exc}$); and/or
- wherein the load circuit (LC) comprises a resistance element ($R_{ex-i}$) particularly serving to limit the load current $i_{e1}(t)$ to a current strength that guarantees an intrinsic safety of the load circuit (LC) or of the transmitter electronics unit.

9. Transmitter electronics unit as claimed in one of the Claims 7 to 8, further comprising a two-wire connection circuit for connecting the transmitter electronics to an evaluation and supply unit situated at a distance.

10. Transmitter electronics as claimed in the previous claim, wherein the two-wire connection circuit is designed to draw the electrical power required for the operation of the driver circuit from the evaluation and supply unit, particularly via a (4 mA to 20 mA) current loop.

11. Transmitter electronics unit as claimed in one of the Claims 7 to 10, further comprising a measuring and command circuit (DSV)

    - with a measuring signal input,
    - with a frequency output, particularly digital
    - and with an amplitude output, particularly digital

        -- wherein the measuring circuit (DSV) is designed to determine a signal frequency and a signal amplitude from an input signal present at the measuring signal input,
        --and wherein the measuring and control circuit (DSV) is designed to output, at the amplitude output, an amplitude sequence, specifically a sequence of amplitude values ($X_{ist}$) determined on the basis of the input signal, particularly digital values and/or values quantifying the signal amplitude of the input signal, and, at the frequency output, to output a frequency sequence, particularly a sequence of frequency values ($F_{IST}$) determined on the basis of the input signal, particularly digital values and/or values quantifying a signal frequency to be set for the input signal.

12. Transmitter electronics as claimed in the previous claim and Claim 9 or 10, wherein the two-wire connection circuit is designed to transmit measured data generated by the measuring and control circuit to the evaluation and supply unit, particularly by the modulation of a current flowing through the two-wire connection circuit and/or serving to provide electrical power for the driver circuit (Exc) and/or the measuring and control circuit (DSV).

13. Measuring system, comprising:

    - a transmitter electronics unit (UE) as claimed in the previous claim ;
    - as well as a transducer (MW) electrically connected to the transmitter electronics unit (UE), said transducer being designed to measure at least one physical measured variable, particularly a mass flow rate and/or a density and/or a viscosity of a fluid conducted in a pipe, or a level of a pourable medium contained in a vessel, and to convert it to a corresponding measuring signal (s1), in such a way that the measuring signal (s1) follows a modification of said physical measured variable with a modification of at least a signal parameter, particularly a signal amplitude, a signal frequency and/or a phase angle.

14. Measuring system as claimed in the previous claim,

    - wherein the frequency output of the measuring and control circuit (DSV) is connected electrically to the frequency control input of the signal generator (SIN) of the driver circuit (Tr) in such a way that the frequency control value applied at its frequency control input corresponds to a frequency value of the frequency sequence;
    - wherein the amplitude output of the measuring and control circuit (DSV) is connected electrically to the amplitude input of the amplitude controller (AMP) of the driver circuit (Tr) in such a way that the amplitude actual value present at its amplitude input corresponds to an amplitude value of the amplitude sequence ;
    - and wherein the transducer (MW) is electrically coupled to the measuring signal input of the measuring and control circuit (DSV) in such a way that the measuring and control circuit (DSV) receives the at least one measuring signal (s1), and that both the frequency sequence and the amplitude sequence depend on the measuring signal (s1).

15. Measuring system as claimed in the previous claim,

    - wherein a measuring and control circuit (DSV) is designed to determine measured values, particularly digital values, representing the at least one physical measured variable, on the basis of the measuring signal (s1); and/or
    - wherein the transducer (MW) is electrically or electromagnetically coupled to the load circuit in such a way that a pattern of the measuring signal (s1) over time depends on a pattern of the load current, $i_{e1}(t)$, and/or of the load voltage, $u_{e1}(t)$, over time particularly in such a way that a signal frequency of the measuring signal (s1) depends on a frequency of the load current or of the load voltage and/or in such a way that a signal amplitude of the measuring signal depends on the current strength of the load current and/or the voltage level of the load voltage; and/or
    - wherein the transducer (MW) has a measuring tube, particularly connected mechanically with a magnet interacting with a coil of the load circuit, said measuring tube being designed to conduct a fluid medium, particularly in that a fluid medium flows through said measuring tube and the tube is allowed to vibrate during the passage of said medium; and/or

- wherein the transducer (MW) has a permanent magnet, particularly in the form of a rod or beaker, which interacts with a coil ($L_{exc}$) incorporated into the load circuit (LC).

16. Measuring system as claimed in one of the Claims 13 to 15, further comprising: an evaluation and supply unit, particularly at a distance from said transmitter electronics unit, wherein the transmitter electronics unit is connected to said evaluation and supply unit.

17. Measuring system as claimed in the previous claim, wherein the transmitter electronics unit draws the electrical power required for the operation of the driver circuit from the measuring and supply unit.

18. Measuring system as claimed in the previous claim, wherein the transmitter electronics unit transmits the measured data generated by the measuring and control circuit - particularly mass flow measured values representing a mass flow rate of a medium flowing through a pipe, density measured values representing a density of a medium, or viscosity measured values representing a viscosity of a medium - to the evaluation and supply unit, particularly by the modulation of a current flowing in a two-wire connection circuit provided in the transmitter electronics unit.

## Revendications

1. Circuit d'attaque, comprenant :

   - un générateur de signaux (SIN)

     -- avec une entrée de commande de fréquence ($f_{set}$),
     -- avec une entrée de commande d'amplitude ($X_{set}$)
     -- et avec une sortie signal ($sin_{exc}$) ;

   - un étage final (Tr)

     -- avec une entrée signal
     -- et avec une sortie charge ;

   - ainsi qu'une commande d'amplitude (AMP)

     -- avec une entrée amplitude,
     -- avec une sortie amplitude,
     -- et avec une entrée de mesure de tension ;

   -- le générateur de signaux (SIN) étant configuré de telle sorte que à délivrer, sur sa sortie signal ($sin_{exc}$), un signal analogique électrique, $u_{sin}(t)$, au moins temporairement périodique, avec une fréquence de signal ($f_{exc}$) prédéfinie par une valeur de commande de fréquence ($F_{set}$) présente à l'entrée de commande de fréquence et une amplitude de tension et/ou courant prédéfinie par une valeur de commande d'amplitude ($X_{set}$) présente à l'entrée de commande d'amplitude ;
   -- l'étage final (Tr) étant conçu de telle sorte à piloter un courant de charge, $i_{e1}(t)$, au moyen d'un circuit impliquant la sortie de charge, avec une intensité de courant dépendant d'une tension de signal et/ou d'un courant de signal d'un signal d'entrée électrique présent à l'entrée du signal, ainsi que pour fournir une tension de charge, $u_{e1}(t)$, avec un niveau de tension dépendant de l'intensité du courant de charge, $i_{e1}(t)$, à ladite sortie de charge ;
   -- la commande d'amplitude (AMP) étant conçue de telle sorte à
   -- déterminer de façon récurrente un écart d'amplitude ($\Delta X$), notamment un écart entre une valeur réelle d'amplitude ($X_{IST}$) présente à l'entrée d'amplitude et une valeur de consigne d'amplitude ($X_{NOM}$),
   -- déterminer de façon récurrente une valeur de l'indicateur (J), laquelle signale si une valeur ($U_M$) d'une tension de mesure, $u_M(t)$, présente à l'entrée de mesure de tension, est trop élevée, notamment si la valeur ($U_M$) a dépassé une valeur seuil ($U_{TH1}$) et, en utilisant la dite valeur de l'indicateur (J), à déterminer une valeur de commande d'amplitude ($X_{exc}$) de telle sorte qu'en cas de valeur trop élevée de la tension de mesure, $u_M(t)$, et/ou qu'en cas de valeur de l'indicateur (J) signalant une valeur trop élevée de la tension de mesure, $u_M(t)$, des valeurs de commande d'amplitude consécutives de la séquence de commande d'amplitude sont diminuées ;
   -- ainsi qu'à émettre, sur la sortie d'amplitude, une séquence de commande d'amplitude, notamment une séquence de valeurs de commande d'amplitude calculées successivement dans le temps ;

   - la sortie signal ($sin_{exc}$) du générateur de signaux (SIN) étant reliée électriquement avec l'entrée signal de l'étage final (Tr) et la sortie de charge de l'étage final avec l'entrée de mesure de tension de la commande d'amplitude (AMP), de telle sorte que

-- l'intensité du courant de charge, $i_{e1}(t)$, délivré par l'étage final (Tr) dépend de la tension et/ou du courant du signal analogique, $u_{sin}(t)$, émis par le générateur de signaux (SIN)

-- et de telle sorte que la tension de charge, $u_e(t)$, est appliquée à l'entrée de mesure de tension de la commande d'amplitude (AMP) ;

- et la sortie d'amplitude de la commande d'amplitude (AMP) étant reliée électriquement avec l'entrée de commande d'amplitude ($X_{set}$) du générateur de signaux (SIN), de telle sorte que l'amplitude de tension et/ou de courant du signal analogique, $u_{sin}(t)$, est prédéfinie par les valeurs de commande d'amplitude - présentes à l'entrée de commande d'amplitude ($X_{set}$) - de la séquence de commande d'amplitude.

2. Circuit d'attaque selon l'une des revendications précédentes,

- pour lequel la commande d'amplitude (AMP) est conçue de telle sorte à déterminer une durée pendant laquelle la tension de mesure, $u_M(t)$, est globalement trop élevée pendant un intervalle de mesure ($\Delta T_M$) prédéfini ;
- et pour lequel la commande d'amplitude (AMP) est conçue de telle sorte à déterminer la valeur de l'indicateur (J) de telle manière à quantifier ladite durée, notamment par rapport audit intervalle de mesure ($\Delta T_M$).

3. Circuit d'attaque selon l'une des revendications précédentes, pour lequel la tension de charge, $u_e(t)$, ainsi que la tension de mesure, $u_M(t)$, présente à l'entrée de mesure de tension de la commande d'amplitude (AMP), présentent au moins temporairement une allure périodique, notamment de telle sorte que la tension de charge, $u_e(t)$, ou la tension de mesure, $u_M(t)$ varie sur une période d'au moins deux périodes à une fréquence prédéfinie ($f_{exc}$) correspondant à la valeur de la commande de fréquence (fset).

4. Circuit d'attaque selon l'une des revendications précédentes,

- pour lequel la commande d'amplitude (AMP) est configurée, dans le cas d'une valeur ($U_M$) élevée de la tension de mesure, $u_M(t)$, de manière à calculer à chaque fois une valeur d'amplitude suivante respective, de telle sorte que ladite valeur de commande d'amplitude soit inférieure à une valeur de commande d'amplitude précédente respective ; et/ou
- pour lequel la commande d'amplitude (AMP) est configurée de manière à déterminer la valeur de l'indicateur (J), de telle sorte à ce que celle-ci signale si l'amplitude ($U_M$) de la tension de mesure, $u_M(t)$, appliquée à l'entrée de mesure de tension, est trop faible, notamment si la valeur est au moins tombée en dessous de la valeur seuil ($U_{TH1}$) ; et/ou

- pour lequel la commande d'amplitude (AMP) est configurée de manière à calculer les valeurs de commande d'amplitude de telle sorte qu'en cas de valeur (UM) trop faible de la tension de mesure, $u_M(t)$, les valeurs de commande d'amplitude successives de la séquence de commande d'amplitude sont augmentées, notamment successivement ; et/ou

- pour lequel la commande d'amplitude (AMP) est configurée de manière à calculer un écart d'amplitude ($\Delta X_{LIM}$) pondéré avec la valeur de l'indicateur (J) de telle sorte que ledit écart d'amplitude ($\Delta X_{LIM}$) pondéré soit inférieur à l'écart d'amplitude ($\Delta X$) lorsque la tension de mesure, $u_M(t)$, est trop élevée ; et/ou

- pour lequel la commande d'amplitude (AMP) est configurée de manière à calculer une valeur de consigne d'amplitude ($X_{LIM}$) pondérée avec la valeur de l'indicateur (J) de telle sorte que ladite valeur de consigne d'amplitude ($X_{LIM}$) pondérée soit inférieure à la valeur de consigne d'amplitude ($X_{NOM}$) lorsque la tension de mesure, $u_M(t)$, est trop élevée ; et/ou

- pour lequel la commande d'amplitude (AMP) est configurée de manière à déterminer dans quelle mesure la tension de mesure, $u_M(t)$, est trop élevée, ou de telle sorte à quantifier une ampleur avec laquelle la tension de mesure, $u_M(t)$, est trop élevée ; et/ou

- pour lequel la commande d'amplitude (AMP) est configurée de manière à déterminer la valeur de l'indicateur (J) de telle sorte que la dite valeur de l'indicateur (J) quantifie une amplitude avec laquelle la tension de mesure, $u_M(t)$, est trop élevée.

5. Circuit d'attaque selon l'une des revendications précédentes, pour lequel la commande d'amplitude (AMP) comprend un premier comparateur (COMP1) avec une entrée de tension non inverseuse et avec une entrée de tension inverseuse, l'entrée de mesure de tension de la commande d'amplitude (AMP) étant constituée de ladite entrée de tension non inverseuse, et une première tension de référence ($+U_{TR}-U_\varepsilon$) étant appliquée à ladite entrée de tension inverseuse.

6. Circuit d'attaque selon l'une des revendications précédentes, pour lequel la commande d'amplitude (AMP) comprend un deuxième comparateur (COMP2) avec une entrée de tension non inverseuse et avec une entrée de tension inverseuse, l'entrée de mesure de tension de la commande d'amplitude (AMP) étant constituée de ladite entrée de tension inverseuse, et une deuxième tension de référence ($-U_{TR}-U_\varepsilon$), différente de la première tension de référence ($+U_{TR}-U_\varepsilon$), étant appliquée à ladite entrée de tension non inverseuse.

7. Électronique de transmetteur, comprenant :

   - un circuit d'attaque (Exc) selon l'une des revendications précédentes ;
   - ainsi qu'un circuit de charge (LC), notamment conçu comme un composant d'un actionneur électromécanique ou électromagnétique d'un transducteur de mesure physico-électrique et/ou formé au moyen d'au moins une bobine ;
   - la sortie de charge de l'étage final (Tr) étant reliée électriquement à la fois à l'entrée de mesure de tension de la commande d'amplitude (AMP) et au circuit de charge (LC), de telle sorte que la tension de charge, $u_{e1}(t)$, soit à la fois présente à l'entrée de mesure de tension de la commande d'amplitude (AMP) et chute aux bornes du circuit de charge (LC).

8. Électronique de transmetteur selon la revendication précédente,

   - pour laquelle le circuit de charge (LC) comprend une bobine ($L_{exc}$) ; et/ou
   - pour laquelle le circuit de charge (LC) comprend un élément résistif ($R_{ex-i}$) servant notamment à la limitation du courant de charge $i_{e1}(t)$ à une intensité garantissant une sécurité intrinsèque du circuit de charge (LC) ou de l'électronique de transmetteur.

9. Électronique de transmetteur selon l'une des revendications 7 à 8, comprenant en outre un circuit de raccordement bifilaire destiné au raccordement de l'électronique de transmetteur à une unité d'exploitation et d'alimentation située à distance de l'électronique.

10. Électronique de transmetteur selon la revendication précédente, pour laquelle le circuit de raccordement bifilaire est conçu de telle sorte à prélever la puissance électrique nécessaire pour le fonctionnement du circuit d'attaque à partir de l'unité d'exploitation et d'alimentation, notamment via la boucle de courant (4 mA à 20 mA).

11. Électronique de transmetteur selon l'une des revendications 7 à 10, comprenant en outre un circuit de mesure et de commande (DSV)

   - avec une entrée de signal de mesure,
   - avec une sortie de fréquence, notamment numérique

   - et avec une sortie d'amplitude, notamment numérique

      -- le circuit de mesure (DSV) étant conçu de telle sorte à déterminer une fréquence et une amplitude d'un signal d'entrée présent à l'entrée de signal de mesure,
      -- et le circuit de mesure et de commande (DSV) étant conçu de telle sorte à délivrer à la sortie d'amplitude une séquence d'amplitudes, à savoir une séquence de valeurs d'amplitude ($X_{ist}$) déterminée sur la base du signal d'entrée, notamment des valeurs numériques et/ou quantifiant l'amplitude du signal d'entrée, et à la sortie de fréquence une séquence de fréquences, à savoir une séquence de valeurs de fréquence ($f_{IST}$) déterminée sur la base du signal d'entrée, notamment des valeurs numériques et/ou quantifiant une fréquence de signal à régler pour le signal d'entrée.

12. Électronique de transmetteur selon la revendication précédente et la revendication 9 ou 10, pour laquelle le circuit de raccordement bifilaire est conçu de telle sorte à transmettre les données de mesure, générées au moyen du circuit de mesure et de commande, à l'unité d'exploitation et d'alimentation, notamment par la modulation d'un courant circulant dans le circuit de raccordement bifilaire et/ou servant à la fourniture de la puissance électrique pour le circuit d'attaque (Exc) et/ou le circuit de mesure et de commande (DSV).

13. Système de mesure, comprenant :

   - une électronique de transmetteur (UE) selon la revendication précédente ;
   - ainsi qu'un transducteur de mesure (MW) raccordé électriquement à l'électronique de transmetteur (UE), lequel transducteur est conçu pour mesurer au moins une grandeur de mesure physique, notamment un débit massique et/ou une densité et/ou une viscosité d'un fluide acheminé dans une conduite, ou un niveau d'un produit déversable contenu dans un réservoir, et pour la convertir en un signal de mesure (s1) correspondant, de telle sorte que le signal de mesure (s1) suive une modification de ladite grandeur de mesure physique avec une modification d'au moins un paramètre du signal, notamment une amplitude du signal, une fréquence du signal et/ou un angle de phase.

14. Système de mesure selon la revendication précédente,

- pour lequel la sortie de fréquence du circuit de mesure et de commande (DSV) est reliée électriquement à l'entrée de commande de fréquence du générateur de signaux (SIN) du circuit d'attaque (Tr) de telle sorte que la valeur de commande de fréquence appliquée à son entrée de commande de fréquence corresponde à une valeur de fréquence de la séquence de fréquences ;

- pour lequel la sortie d'amplitude du circuit de mesure et de commande (DSV) est reliée électriquement à l'entrée d'amplitude de la commande d'amplitude (AMP) du circuit d'attaque (Tr) de telle sorte que la valeur d'amplitude réelle présente à l'entrée d'amplitude corresponde à une valeur d'amplitude de la séquence d'amplitudes ;

- et pour lequel le transducteur de mesure (MW) est couplé électriquement à l'entrée du signal de mesure du circuit de mesure et de commande (DSV) de telle sorte que le circuit de mesure et de commande (DSV) reçoit l'au moins un signal de mesure (s1), et qu'à la fois la séquence de fréquences et la séquence d'amplitudes dépendent du signal de mesure (s1).

15. Système de mesure selon la revendication précédente,

- pour lequel un circuit de mesure et de commande (DSV) est conçu pour déterminer les valeurs mesurées, notamment numériques, représentant l'au moins une grandeur de mesure physique, sur la base du signal de mesure (s1) ; et/ou

- pour lequel le transducteur de mesure (MW) est couplé électriquement et/ou électromagnétiquement au circuit de charge de telle sorte qu'une caractéristique temporelle du signal de mesure (s1) dépend d'une caractéristique temporelle du courant de charge, $i_{e1}(t)$, et/ou de la tension de charge, $u_{e1}(t)$, notamment de telle sorte qu'une fréquence du signal de mesure (s1) dépend d'une fréquence du courant de charge ou de la tension de charge et/ou de telle sorte qu'une amplitude du signal de mesure dépend de l'intensité du courant de charge et/ou du niveau de la tension de charge ; et/ou

- pour lequel le transducteur (MW) comporte un tube de mesure, notamment relié mécaniquement à un aimant interagissant avec une bobine du circuit de charge, lequel tube de mesure est conçu pour acheminer un produit fluide, lequel tube de mesure est notamment parcouru par un produit fluide et amené à vibrer pendant le passage dudit produit ; et/ou

- pour lequel le transducteur de mesure (MW) comporte un aimant permanent, notamment en forme de tige ou en forme de coupelle, lequel aimant interagit avec une bobine ($L_{exc}$) incorporée dans le circuit de charge (LC).

16. Système de mesure selon l'une des revendications 13 à 15, comprenant en outre : une unité d'exploitation et d'alimentation, notamment se trouvant à distance de l'électronique de transmetteur, l'électronique de transmetteur étant raccordée à ladite unité d'exploitation et d'alimentation.

17. Système de mesure selon la revendication précédente, pour lequel l'électronique de transmetteur prélève la puissance électrique nécessaire pour le fonctionnement du circuit d'attaque à partir de l'unité de mesure et d'alimentation.

18. Système de mesure selon la revendication précédente, pour lequel l'électronique de transmetteur transmet les données de mesure - notamment des valeurs mesurées de débit massique représentant un débit massique d'un produit s'écoulant dans une conduite, des valeurs mesurées de densité représentant une densité d'un produit ou des valeurs mesurées de viscosité représentant une viscosité d'un produit - générées au moyen du circuit de mesure et de commande, à l'unité d'exploitation et d'alimentation, notamment par la modulation d'un courant circulant dans le circuit de raccordement bifilaire prévu dans l'électronique de transmetteur.

Fig. 1

*Fig. 2*

**Fig. 3**

EP 3 497 411 B1

Fig. 4

**Fig. 5**

EP 3 497 411 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3934007 A
- EP 1058093 A
- EP 1158289 A
- EP 525920 A
- EP 984248 A
- US 3764880 A
- US 3878725 A
- US 4308754 A
- US 4317116 A
- US 4468971 A
- US 4524610 A
- US 4574328 A
- US 4594584 A
- US 4617607 A
- US 4656353 A
- US 4768384 A
- US 4850213 A
- US 4926340 A
- US 5024104 A
- US 5052230 A
- US 5068592 A
- US 5131279 A
- US 5207101 A
- US 5231884 A
- US 5359881 A
- US 5363341 A
- US 5416723 A
- US 5469748 A
- US 5535243 A
- US 5604685 A
- US 5672975 A
- US 5687100 A
- US 5742225 A
- US 5796011 A
- US 5959372 A
- US 6006609 A
- US 6014100 A
- US 6140940 A
- US 6236322 B
- US 6269701 B
- US 6285094 B
- US 6311136 B
- US 6397683 B
- US 6476522 B
- US 6480131 B
- US 6487507 B
- US 6512358 B
- US 6535161 B
- US 6574515 B
- US 6577989 B
- US 6662120 B
- US 6769301 B
- US 6776053 B
- US 6799476 B
- US 7200503 B
- US 7630844 B
- US 20080015799 A
- US 20110271756 A
- US 20150177192 A
- WO 2014163635 A
- WO 0014485 A
- WO 0026739 A
- WO 0036379 A
- WO 0048157 A
- WO 0067087 A
- WO 0102816 A
- WO 02086426 A
- WO 02103327 A
- WO 0245045 A
- WO 2004048905 A
- WO 2005040735 A
- WO 2006130087 A
- WO 2010014102 A
- WO 8802476 A
- WO 8802853 A
- WO 9516897 A
- US 6397683 A
- EP 903651 A
- EP 1008836 A
- WO 9902945 A
- WO 05040735 A
- WO 04048905 A
- WO 9420940 A
- EP 1147841 A